# EUROPEAN PATENT APPLICATION

(11) **EP 1 557 481 A2**
(43) Date of publication of application: **27.07.2005**
(21) Application number: 05001099.0
(22) Date of filing: 20.01.2005
(51) Int. Cl.: C23C 18/12

(54) **Ferroelectric film, ferroelectric memory, and piezoelectric element**

(30) Priority: 20.01.2004 JP 2004012160
(71) Applicant: SEIKO EPSON CORPORATION, Tokyo 160-0811 (JP)
(72) Inventor: Kijima, Takeshi, Suwa-shi, Nagano-ken 392-8502 (JP); Miyazawa, Hiromu, Suwa-shi, Nagano-ken 392-8502 (JP); Hamada, Yasuaki, Suwa-shi, Nagano-ken 392-8502 (JP)
(74) Representative: Hoffmann, Eckart, Dipl.-Ing.

(57) **Abstract**

A ferroelectric film comprised of a perovskite structure ferroelectric represented by ABO₃, includes at least one type of Si²⁺, Ge²⁺ and Sn²⁺ as an A site doping ion, and at least Nb⁵⁺ as a B site doping ion.

## Description

The present invention relates to ferroelectric films. Also, the present invention relates to ferroelectric memories and piezoelectric elements, which have ferroelectric films.

Conventionally, Pb (Zr, Ti) O₃ (PZT) is known as a perovskite structure ferroelectric expressed as ABO₃.

PZT-based materials that are used for ferroelectric memories (FeRAMs) that have been so far placed in practical use have a B site composition with a Zr/Tr ratio being in a range between 52/48 and 40/60, and most of them use the mixed region of the tetragonal crystal and the rhombohedral crystal. The aforementioned compositions have mainly been used in conventional FeRAMs, for empirical reasons in that their reliability can be readily secured.

However, in this region, a so-called P-E hysteresis has a round shape and its squareness is not sufficient. That the hysteresis (exactly: the shape of the hysteresis) is round means that, at the time of polarization reversion, various reversion voltages are present from low to high when individual polarization components reverse. This happens because, in the tetragonal crystal and the rhombohedral crystal in PZT, the tetragonal crystal has a polarization axis <001> and the rhombohedral crystal has a polarization axis <111>, which are different from each other. In other words, when the hysteresis is round, there is a possibility that, when a predetermined potential is applied, polarization components that reverse at a lower voltage gradually reverse, and data may be lost. Accordingly, it may intrinsically have weak data retention characteristics. By this token, to allow some hysteresis shift, FeRAMs that have been put to practical use so far adopt 3 - 5 V driving which is about three times the coercive voltage (Vc).

The mass production of FeRAMs started at first from the MPB composition (coexisting phase of boundaries of the tetragonal crystal region and the rhombohedral crystal region) of PZT, because they empirically proved highly reliable. However, it may be more appropriate to think that PZT within a certain composition range that should essentially exhibit high reliability ruins its reliability for some other reasons. In this respect, in order to improve the squareness of the P-E hysteresis, all of the polarization components only have to have polarization inversion at the same time with the same voltage. In other words, it is considered to be important that the crystal system is unified in one of the crystal systems, for example, either the tetragonal crystal or the rhombohedral crystal, and the 90° domain and the 180° domain are oriented in a reversing direction at the same time with the same voltage. Stated otherwise, it is important to engineer the domains.
On the other hand, in view of the fact that Pt (111) and Ir (111) have conventionally been used almost always as electrode materials for the use of ferroelectric capacitors, tetragonal PZT may be used because PZT to be used can also be easily oriented to (111), and (111) oriented PZT whose engineered domain can be effectively used. On the other hand, it is conventionally known that tetragonal PZT has poor reliability.

In other words, the more tetragonal PZT (Ti-rich regions) is present, the greater the leakage current becomes, and there is notable deterioration in static imprint characteristics (the amount of shift of data in the direction along an axis of applied voltage in a P-V hysteresis curve, when the data is read out, after having once been written and retained for a predetermined period of time at room temperature or in a heated environment), and in data retention characteristics (the amount of shift of data in the direction along an axis of remanence in a P-V hysteresis curve, when the data is read out after having once been written and retained for a predetermined period of time at room temperature or in a heated environment).

As regards the prior art reference is made to J. Cross, M. Fujiki, M. Tsukada, K. Matsuura, S. Otani, M. Tomotani, Y. Kataoka, Y. Kotaka and Y. Goto, Integ. Ferroelectrics, 25, 265 (1999); I. Stolichnov, A. Tagantsev, N. Setter, J. Cross and M. Tsukada, Appl. Phys. Lett., 74, 3552 (1999); and T. Morimoto, O. Hidaka, Y. Yamakawa, O. Ariusumi, H. Kanaya, T. Iwamoto, Y. Kumura, I. Kunishima and A. Tanaka, Jpn. J. Appl. Phys., 39, 2110 (2000).

It is an object of the present invention to provide ferroelectric films with which highly reliable ferroelectric devices can be obtained. Another object of the present invention is to provide ferroelectric memories and piezoelectric elements which use the ferroelectric films.

This object is achieved by
a ferroelectric film as claimed in claims 1 and 2, respectively. Preferred embodiments and applications of the invention are subject-matter of the dependent claims.

In accordance with one embodiment of the present invention, because Nb and O have a strong covalent bond, oxygen vacancies that is one of the factors to determine the reliability of the perovskite structure ferroelectric can be effectively prevented. Also, in accordance with the present invention, both Nb and Si may both be added to the perovskite structure ferroelectric, such that a sufficient amount of Nb can become a solid solution in the B site.

In accordance with another embodiment of the present invention, because Nb has a stable valence which is +5, its valence is +1 or more greater than the valence of the B site ion. For this reason, in accordance with the present invention, this surplus valence can prevent a vacancy of oxygen (a valence of -2) ion. In other words, when the B site ion is replaced with the added Nb ion, a vacancy of the oxygen ion can be prevented, and the charge neutrality in the perovskite structure can be established. For example, when the perovskite structure ferroelectric represented by ABO₃ is a PZT-based ferroelectric, a ferroelectric film is formed such that the sum (the amount of added Nb x (a valence of +1)) of the valence of the A site compensating ion of +2 and an excess valence of +1 ((Nb : a valence of +5) - (Ti: a valence of +4) = (a valence of +1)) caused by doping of the B site compensating ion equals to or less than a shortage valence corresponding to the oxygen ion vacancies (the amount of oxygen ion vacancies x (a valence of -2)).

(8) The present invention is applicable to a ferroelectric memory that includes the ferroelectric film described above.

(9) The present invention is applicable to a piezoelectric element that includes the ferroelectric film described above.

Preferred embodiments of the present invention are described below with reference to the accompanying drawings.
- FIG. 1: A cross-sectional view schematically showing a ferroelectric capacitor in accordance with an embodiment.
- FIG. 2: A graph showing XRD patterns of PT films manufactured while changing the amount of added Si from 0 to 20 mol%.
- FIG. 3: Graphs showing XRD patterns of a PT film in which the amount of added Si is 20 mol%.
- FIG. 4: An image showing the surface morphology of a PT film in which Si is not added.
- FIG. 5: An image showing the surface morphology of a PT film in which the amount of added Si is 2 mol%.
- FIG. 6: An image showing the surface morphology of a PT film in which the amount of added Si is 4 mol%.
- FIG. 7: An image showing the surface morphology of a PT film in which the amount of added Si is 12 mol%.
- FIG. 8: An image showing the surface morphology of a PT film in which the amount of added Si is 14 mol%.
- FIG.9: An image showing the surface morphology of a PT film in which the amount of added Si is 16 mol%.
- FIG. 10: An image showing the surface morphology of a PT film in which the amount of added Si is 18 mol%.
- FIG. 11: An image showing the surface morphology of a PT film in which the amount of added Si is 20 mol%.
- FIG. 12: TEM images of PT films when the amount of added Si is 16 mol% and 18 mol%, respectively.
- FIG. 13: A graph showing a Raman spectra chart of a PT film in which the amount of added Si is 16 mol%.
- FIG. 14: Graphs showing results of analysis by a Raman spectroscopy conducted on PT films that are manufactured while changing the amount of added Si from 0 - 20 mol%.
- FIG. 15: A graph showing the hysteresis characteristics of a PT film in which the amount of added Si is 12 mol%.
- FIG. 16: A graph showing the hysteresis characteristics of a PT film in which the amount of added Si is 14 mol%.
- FIG. 17: A graph showing the hysteresis characteristics of a PT film in which the amount of added Si is 16 mol%.
- FIG. 18: A graph showing the hysteresis characteristics of a PT film in which the amount of added Si is 18 mol%.
- FIG. 19: A graph showing the hysteresis characteristics of a PT film in which the amount of added Si is 20 mol%.
- FIG. 20: A graph showing the hysteresis characteristics of a PT film having a film thickness of 60 nm.
- FIG. 21: A graph showing the hysteresis characteristics of a PT film having a film thickness of 120 nm.
- FIG. 22: A graph showing the hysteresis characteristics of a PT film having a film thickness of 240 nm.
- FIG.23: Images showing the surface morphologies of PZT films with Zr/Ti ratio being 30/70 and 20/80, respectively.
- FIG. 24: Graphs showing the hysteresis characteristics of a PZT films with Zr/Ti ratio being 30/70 and 20/80, respectively.
- FIG. 25: A graph showing the leakage current characteristics of PZT films in which Si is added by 16 mol%.
- FIG. 26: A graph showing the fatigue characteristics of PZT films in which Si is added by 16 mol%.
- FIG. 27: A graph showing the static imprint characteristics of PZT films in which Si is added by 16 mol%.
- FIG. 28: SEM cross-sectional images of PZT films having a film thickness ranging from 60 nm - to 240 nm.
- FIG. 29: Images showing the surface morphologies of PZTN films manufactured with Si added.
- FIG. 30: Graphs showing XRD patterns of a PZTN film, PZT film and PZTS film manufactured with Si added.
- FIG. 31: SEM cross-sectional images of PZTN films manufactured with Si added.
- FIG. 32: Graphs showing the hysteresis characteristics of PZTN films having a film thickness of 100 nm, 150 nm and 200 nm.
- FIG. 33: Graphs showing the relation between the amount of added Nb and the hysteresis characteristics.
- FIG. 34: A graph showing the relation between the amount of added Nb and the leakage characteristics.
- FIG. 35: A graph showing the leakage characteristics of PZT, PZT in which Si is added by 16 mol% using PbSiO₃, and PZTN.
- FIG. 36: A graph showing the fatigue characteristics of PZT, PZT in which Si is added by 16 mol% using PbSiO₃, and PZTN.
- FIG. 37: A graph showing the static imprint characteristics of a PZTN film obtained when data is retained at 125 °C for 272 hours.
- FIG. 38: A graph showing the dynamic imprint characteristics of PZTN films obtained in a constant temperature environment at 85 °C.
- FIG. 39: A graph showing the static imprint characteristics of PZTN films obtained in a constant temperature environment at 150 °C.
- FIG. 40: A graph showing the static imprint characteristics of PZT (Zr/Ti = 20/80) films obtained in a constant temperature environment at 150 °C.
- FIG. 41: A graph showing the static imprint characteristics of PZT (Zr/Ti = 30/70) films obtained in a constant temperature environment at 150 °C.
- FIG. 42: A graph showing results of secondary ion mass spectrometry (SIMS) conducted on PZTN films.
- FIG. 43: A graph showing results of secondary ion mass spectrometry (SIMS) conducted on PZTN films.
- FIG. 44: A graph showing results of secondary ion mass spectrometry (SIMS) conducted on PZTN films.
- FIG. 45: A graph showing Raman spectra of PTN (PbTi₁₋ₓNbₓO₃ : X = 0 - 0.3).
- FIG. 46: A graph showing the relation between peaks indicating vibrational modes originating from the B site ion called A₁(2TO) and the amount of added Nb.
- FIG. 47: TEM cross-sectional images of a PZT (Zr/Ti = 40/60)/Pt/TiOₓ capacitor.
- FIG. 48: TEM cross-sectional images of a PZTN (Zr/Ti/Nb = 20/60/20)/Pt/TiOₓ capacitor.
- FIG. 49: A graph showing the hysteresis characteristics of a capacitor processed in a size of 0.8 µm × 0.8 µm.
- FIG. 50: A graph showing the hysteresis characteristics of a capacitor processed in a size of 1 µm × 1 µm.
- FIG. 51: A graph showing the hysteresis characteristics of a capacitor processed in a size of 2 µm × 2 µm.
- FIG. 52: A graph showing the hysteresis characteristics of a capacitor processed in a size of 3 µm × 3 µm.
- FIG. 53: A graph showing the hysteresis characteristics of a capacitor processed in a size of 5 µm × 5 µm.
- FIG. 54: A graph showing the hysteresis characteristics of a capacitor processed in a size of 10 µm × 10 µm.
- FIG. 55: A graph showing the hysteresis characteristics of a capacitor processed in a size of 20 µm × 20 µm.
- FIG. 56: A graph showing the hysteresis characteristics of a capacitor processed in a size of 50 µm × 50 µm.
- FIG. 57: A graph showing the hysteresis characteristics of a capacitor processed in a size of 100 µm × 100 µm.
- FIG. 58: A graph showing results obtained by first-principles simulation.
- FIG. 59: Graphs showing hysteresis characteristics of PZTV (Zr/Ti/V = 20/60/20), PZTW (Zr/Ti/W = 20/70/10), and PZTTa (Zr/Ti/Ta = 20/60/20).
- FIG. 60: Graphs showing electronic density of states of PZT and PZTN systems.
- FIG.61: A plan view and a cross-sectional view schematically showing a simple matrix type ferroelectric memory device in accordance with an embodiment.
- FIG. 62: A cross-sectional view showing an example of a ferroelectric memory device in accordance with an embodiment in which a memory cell array is integrated with a peripheral circuit on the same substrate.
- FIG. 63: A cross-sectional view and a circuit diagram schematically showing a 1T1C type ferroelectric capacitor in accordance with a modified example of an embodiment of the present invention.
- FIG. 64: An exploded perspective view showing an ink-jet recording head in accordance with an embodiment of the present invention
- FIG. 65: A plan view and a cross-sectional view of a recording head in accordance with an embodiment of the present invention.
- FIG. 66: A view schematically showing a layered structure of a piezoelectric element in accordance with an embodiment of the present invention.
- FIG. 67: A view schematically showing one example of an ink-jet recording apparatus in accordance with an embodiment of the present invention.

### 1. Ferroelectric Film and Ferroelectric Capacitor Using the Same

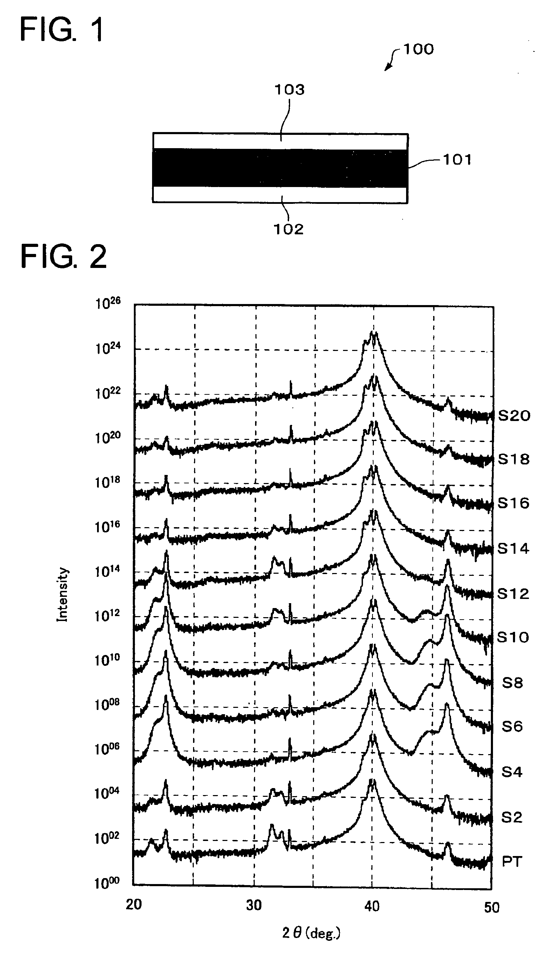

Fig. 1 is a cross-sectional view schematically showing a ferroelectric capacitor 100 using a ferroelectric film 101 in accordance with an embodiment of the present invention.

As shown in FIG. 1, the ferroelectric capacitor 100 is formed from the ferroelectric film 101 that is composed of a perovskite structure ferroelectric represented by ABO₃, a first electrode 102 and a second electrode 103.

The first electrode 102 and the second electrode 103 may be formed from a single precious metal such as Pt, Ir, Ru, or the like, or a composite material mainly composed of the above-mentioned precious metals. If elements of the ferroelectric diffuse into the first electrode 102 and the second electrode 103, composition shifts occur at the interfaces between the electrodes and the ferroelectric film 101, and the squareness of its hysteresis deteriorates. Accordingly, the first electrode 102 and the second electrode 103 are required to have a density which does not allow diffusion of the elements of the ferroelectric. In order to increase the density of the first electrode 102 and the second electrode 103, for example, a method of forming a film by sputtering using a gas with a large mass, or a method of dispersing an oxide of Y, La, or the like into the noble metal electrode is employed.

The ferroelectric film 101 is formed by using a PZT-based ferroelectric composed of oxides including Pb, Zr and Ti as constituent elements. In particular, the present embodiment is characterized in that the ferroelectric film 101 uses Pb (Zr, Ti, Nb) O₃ (PZTN) in which Nb is doped in the Ti site (B site). In other words, in accordance with the present embodiment, Nb⁵⁺ is added as a Ti site compensating ion.

Because Nb has generally the same size as that of Ti (ionic radii are close to each other and atomic radii are identical), and two times the weight, it is hard for atoms to escape the lattice even by collision among atoms by lattice vibration. Also its atomic valence is stable at +5, such that even if Pb escapes, the valence of the escaped Pb can be supplemented by Nb⁵⁺. Also at the time of crystallization, even when escape of Pb occurs, it is easier for Nb having a smaller size to enter than O having a greater size to escape.

Further, Nb with a valence of +4 also exists, and therefore can be sufficiently substituted for Ti⁴⁺. Furthermore, it is believed that Pb does not escape easily because Nb has in effect a very strong covalent bond (H. Miyazawa, E. Natori, S. Miyashita; Jpn. J. Appl. Phys. 39 (2000) 5679).

So far, Nb doping in PZT has been conducted mainly in the Zr-rich rhombohedral crystal region, but its amount is about 0.2 - 0.025 mol%, which is extremely small (J. Am. Ceram. Soc. 84 (2001) 902; Phys. Rev. Let. 83 (1999) 1347). The reason why a larger amount of Nb could not be doped is believed to be that the crystallization temperature rises to 800 °C or higher when Nb is added by 10 mol%, for example.

Accordingly, the ferroelectric film 101 in accordance with the present embodiment is further added with a PbSiO₃ silicate (Si²⁺ ion). As a result, the crystallization energy of PZTN can be reduced. In other words, when PZTN is used as a material of the ferroelectric film 101, by adding Nb and PbSiO₃ together, the crystallization temperature of the PZTN can be lowered. Also, a germanate (Ge²⁺) may be used instead of a silicate (Si²⁺ ion), and in addition, another compound including Sn²⁺ ion may be added. In other words, in accordance with the present embodiment, at least one type of Si²⁺, Ge²⁺ and Sn²⁺ ions can be added as a Pb site (A site) compensating ion.

Also, in accordance with the present embodiment, in the ferroelectric film 101, Pb may be replaced with an element with a valence of +3 to prevent Pb from escaping. A lanthanoid element, such as, La, Ce, Pr, Nd, Pm, Sm, Eu, Gd, Tb, Dy, Ho, Er, Tm, Yb, and Lu may be enumerated as a representative element.

Next, an example of a film forming method to form the PZTN ferroelectric film 101 that is used in the ferroelectric capacitor 100 in accordance with an embodiment is described.

The PZTN ferroelectric film 101 can be obtained by preparing a mixed solution of three raw material liquids including at least one of Pb, Zr, Ti and Nb, and crystallizing oxides contained in the mixed solution by heat treatment or the like.

The first raw material liquid may be, for example, a solution in which a condensation polymer for forming PbZrO₃ perovskite crystal with Pb and Zr among the constituent metal elements of the PZTN ferroelectric phase is dissolved in a solvent such as n-buthanol in an anhydrous state.

The second raw material liquid may be, for example, a solution in which a condensation polymer for forming PbTiO₃ perovskite crystal with Pb and Ti among the constituent metal elements of the PZTN ferroelectric phase is dissolved in a solvent such as n-buthanol in an anhydrous state.

The third raw material liquid may be, for example, a solution in which a condensation polymer for forming PbNbO₃ perovskite crystal with Pb and Nb among the constituent metal elements of the PZTN ferroelectric phase is dissolved in a solvent such as n-buthanol in an anhydrous state.

For example, when the ferroelectric film 101 composed of PbZr_{0.2}Ti_{0.8}Nb_{0.2}O₃ (PZTN) is to be obtained by using the first, second and third raw material liquids, they are mixed in a mixing ratio ((the first raw material liquid) : (the second raw material liquid) : (the third raw material liquid)) of 2 : 6 : 2. However, a high crystallization temperature would be required to form the PZTN ferroelectric film 101 if the mixed solution is crystallized as it is. More specifically, the addition of Nb abruptly increases the crystallization temperature, making crystallization impossible in the temperature range that enables creation of elements below 700°C. Therefore, conventionally, Nb has not been used in the amount of 5 mol% or greater as a replacement element for Ti, rather Nb is limited to the use only as an additive. In addition, there have been no cases of PZT tetragonal crystals in which Ti is contained in an amount greater than Zr. This is obvious from documents, such as, J. Am. Ceram. Soc, 84 (2001) 902 and Phys. Rev. Let, 83 (1999) 1347.

Accordingly, in the present embodiment, the above-described problem can be solved by further adding to the above-described mixed solution a solution, as a fourth raw material liquid, in which a condensation polymer for forming PbSiO₃ crystal is dissolved in a solvent such as n-buthanol in an anhydrous state by 1 mol% or greater but less than 5 mol% to form a mixed solution.

In other words, by using the mixed solution of the first, second, third and fourth liquids, the crystallization temperature of PZTN can be lowered, and the PZTN can be crystallized in an element creatable temperature range below 700 °C.

More specifically, a series of steps consisting of a mixed solution coating step, an alcohol removal step, a dry thermal treatment step, and a cleaning thermal treatment step is conducted a desired number of times, and then a sintering step is conducted for crystallization annealing to form the ferroelectric film 101.

Examples of the conditions in each of the steps are given below.

First, a lower electrode is formed by coating a precious metal for electrodes such as Pt or the like on an Si substrate. Then, the mixed liquid is coated by a coating method such as spin coating. More specifically, the mixed solution is dripped onto the Pt coated substrate. In order to spread the dripped mixed solution over the entire substrate surface, the substrate is rotated at about 500 rpm, and then the rotation speed is reduced to 50 rpm or below for about 10 seconds. The dry thermal treatment step is conducted at 150 °C - 180 °C. The dry thermal treatment step is conducted by using a hot-plate or the like in the atmosphere. Similarly, the cleaning thermal treatment step is conducted in the atmosphere using the hot-plate, which is held at 300 °C - 350 °C. The sintering step for crystallization is conducted by using rapid thermal annealing (RTA) or the like in an oxygen atmosphere.

The film thickness after sintering can be about 100 - 200 nm. After the first electrode has been formed by sputtering or the like, post-annealing is conducted for the purpose of forming an interface between the second electrode and the ferroelectric thin film and improving the crystallinity of the ferroelectric thin film, using RTA or the like in an oxygen atmosphere in a manner similar to the sintering step, thereby obtaining the ferroelectric capacitor 100.

### Example 1

Si was added as PbSiO₃ by 20 mol% or less to 1 mol of PbTiO₃. Hereunder, Si in the description means to be Si that is added as PbSiO₃. In the present example, Si that is added to a perovskite structure ferroelectric would never be added in the form of SiO₂. It is noted that, when TEOS or alkoxide of Si is added, in other words, SiO₂ is directly added, SiO₂ initially covers the surface of the Pt electrode, and perovskite crystal could not be obtained.
In the present example, PbTiO₃ films were formed with Si added under the conditions in Table 1. It is noted that, in the following examples, the case where no PbSiO₃ is added is expressed by an abbreviation as PT or S0, when the amount of added Si is 2 mol%, it is expressed as S2, and so forth.

**Table 1**

| Manufacturing conditions | |
|---|---|
| Composition | Pt(Pb/Ti = 110/100) - PbSi (2 ~ 20 mol%) |
| | PZT(Pb/Zr/Ti = 110/20/80 or 110/30/70) + PbSi (2 - 20 mol%) |
| Rotation speed | 2000 ~ 5000 rpm |
| Heat treatment | 650 °C |

| Sintering condition | |
|---|---|
| Lower electrode | Pt//TiOₓ /SiO₂/ Si (2 steps) |
| Coating | 2000 ~ 5000 rmp, 30 sec. |
| Drying + Sintering | 150 °C, 2 min. + 300 °C, 4 min. |
| Crystallization | 550 °C, 5 min., O₂, 50 °C/sec. |
| Upper electrode | Pt |
| Post Annealing | 650 °C, 15 min., O₂, 50 °C/sec. |

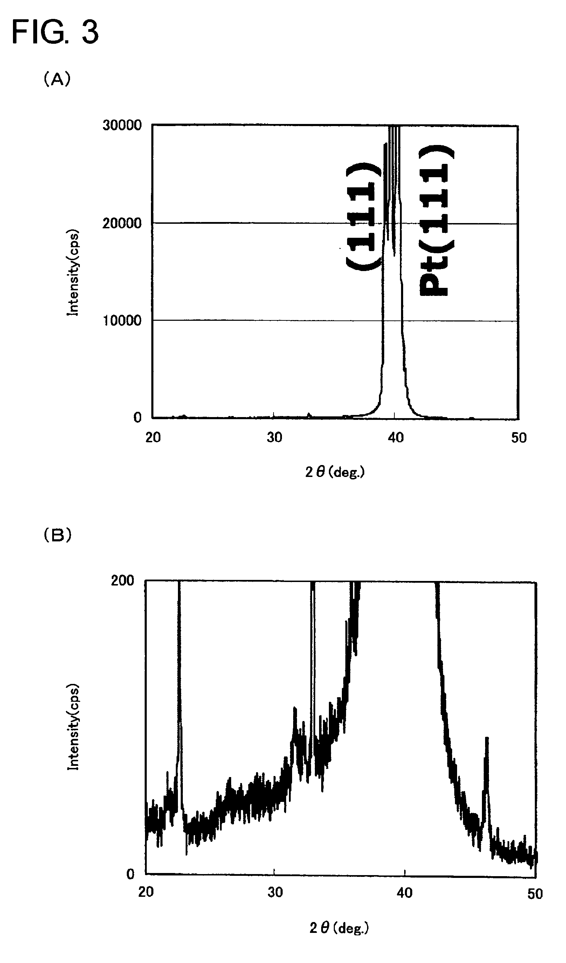

XRD patterns of the samples obtained in the present example are shown in FIG. 2 and FIGS. 3 (A) and 3 (B). FIG. 2 shows XRD patterns of PT films manufactured while changing the amount of added Si from 0 to 20 mol%, wherein the ordinate is shown in a logarithmic scale. FIGS. 3 (A) and (B) show XRD patterns of PT films when the amount of added Si is 20 mol%, wherein the ordinates are shown in a linear scale.

According to FIG. 2, it was confirmed that all of the PT films were in a perovskite single phase. Also, according to FIGS. 3 (A) and (B), it was confirmed that the PT films were (111) single oriented films having almost no heterogeneous phase.

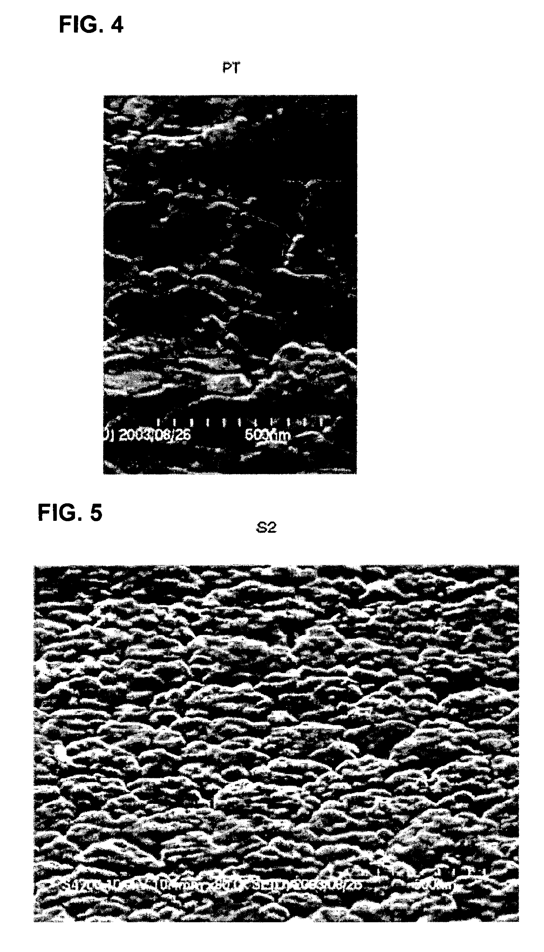

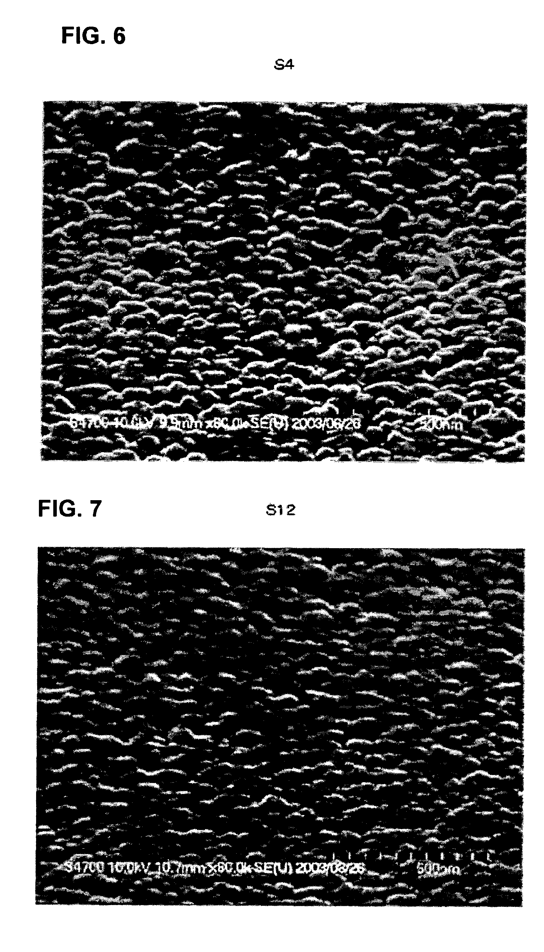

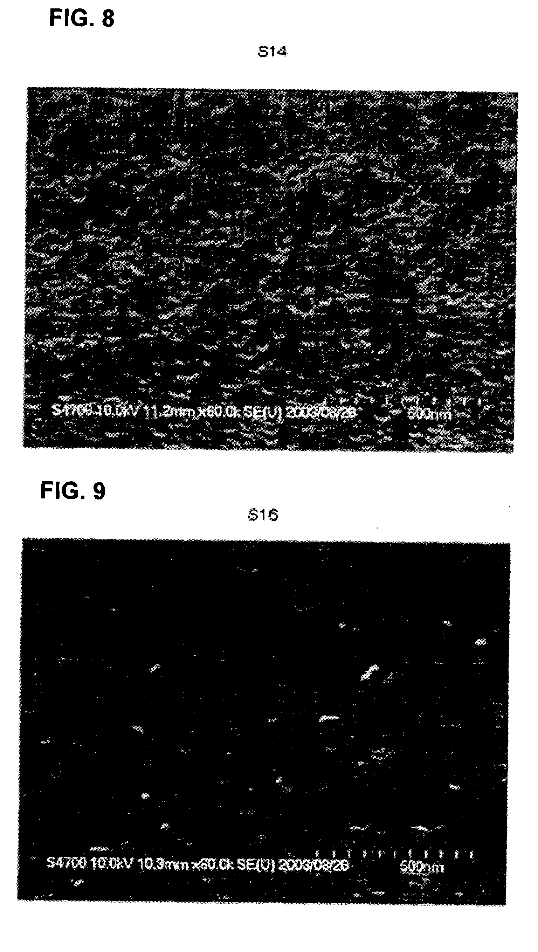

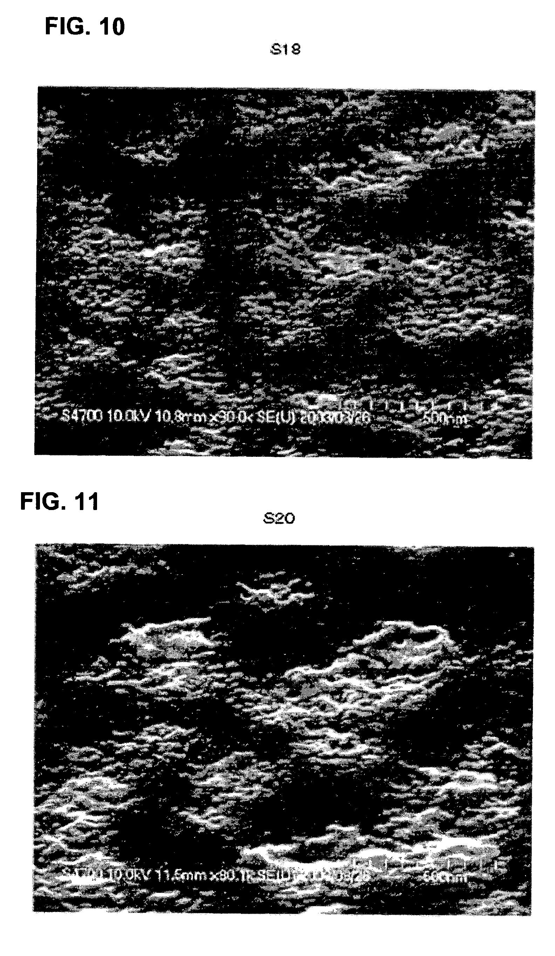

Also, FIGS. 4 to 11 shows surface morphologies of PT films obtained in accordance with the present embodiment. It is understood from FIGS. 4 to 11 that the grain size of PT crystal becomes finer with addition of Si. In particular, a very good flatness was exhibited at S16, but some heterogeneous phase was observed on the surface at S18 and above where the amount of added Si exceeded 18 mol%. The heterogeneous phase is assumed to be an amorphous phase because no heterogeneous phase is observed in the XRD patterns shown in FIG. 2.

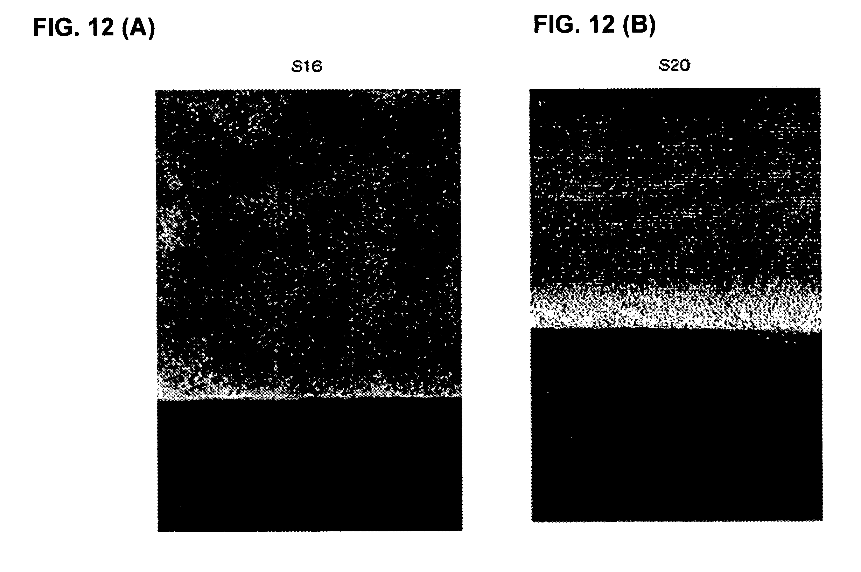

Then, among the PT films of the present example, Sample S16 with the amount of added Si being 16 mol% and Sample S20 with the amount of added Si being 18 mol% were compared by means of TEM images, and results shown in FIG. 12 (A) and (B) were obtained. According to FIG. 12 (A), no heterogeneous phase existed in an interface section between Sample S16 and the Pt electrode, and an excellent perovskite structure crystal phase was observed. On the other hand, according to FIG. 12 (B), in the case of Sample S20, amorphous phases were observed not only on its surface but also in its interface section with the Pt electrode.

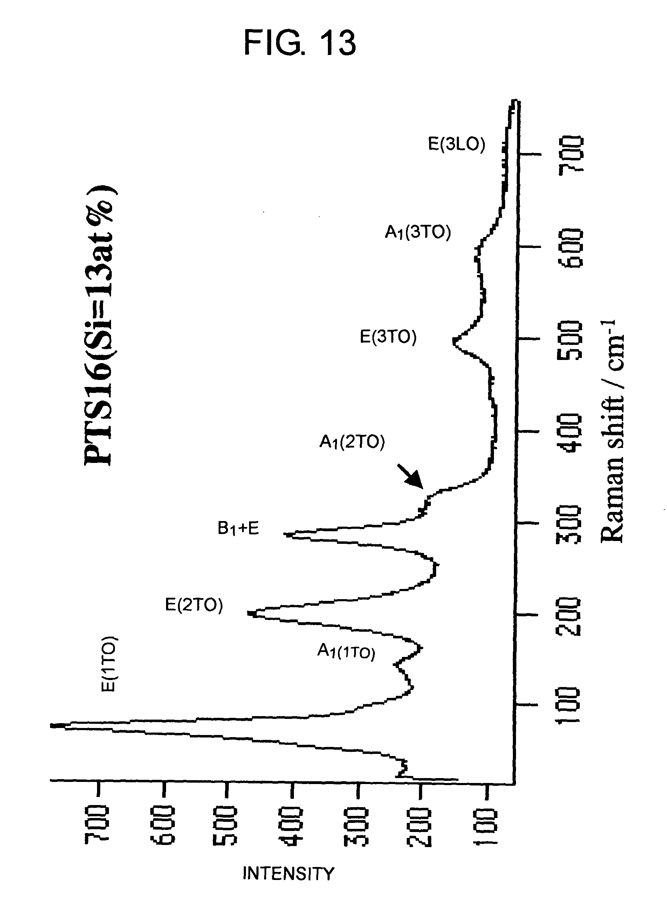

Also, the PT film of Sample S16 was analyzed by Raman spectroscopy, and FIG. 13 is a Raman spectra chart obtained. According to FIG. 13, a vibration mode only from the perovskite phase was observed, like in the analysis results by XRD patterns and the observation results by TEM images.

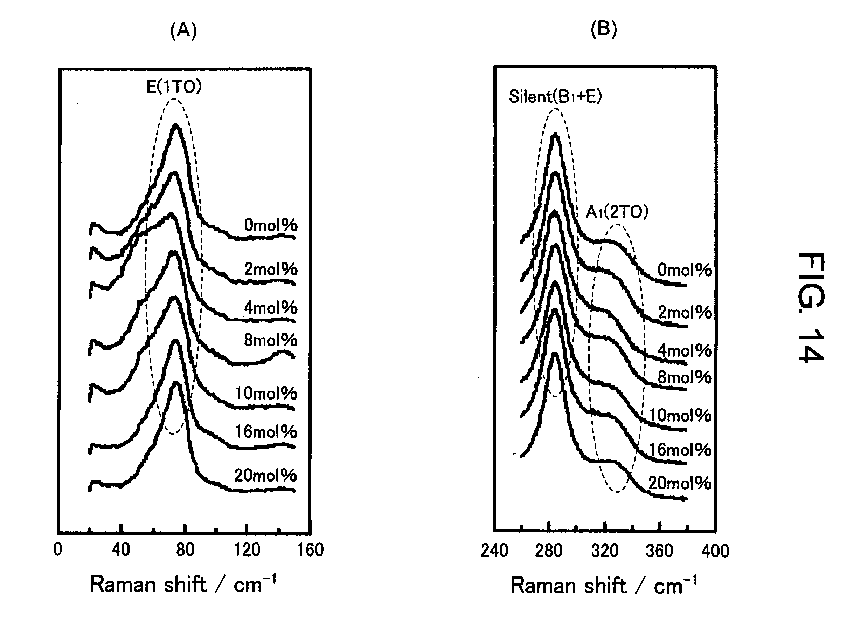

FIG. 14 shows Raman spectra of all of the PT films in accordance with the present example obtained by Raman spectroscopy. As shown in FIG. 14, changes of the peaks indicating the vibrational mode E (1TO) of the A site ion were observed as the amount of added Si was increased, whereas changes in the vibrational mode A₁ (2TO) of the B site ion were not observed at all. Therefore, it was confirmed that Si became Si²⁺, and partially replaced Pb in the A site. However, at S18 and above, the peak shift of the vibrational mode of the A site becomes small, which indicated that Si of 16 mol% or greater did not contribute to the A site replacement. Accordingly, the amorphous phase observed in the PT films of the present example is believed to be SiO₂.

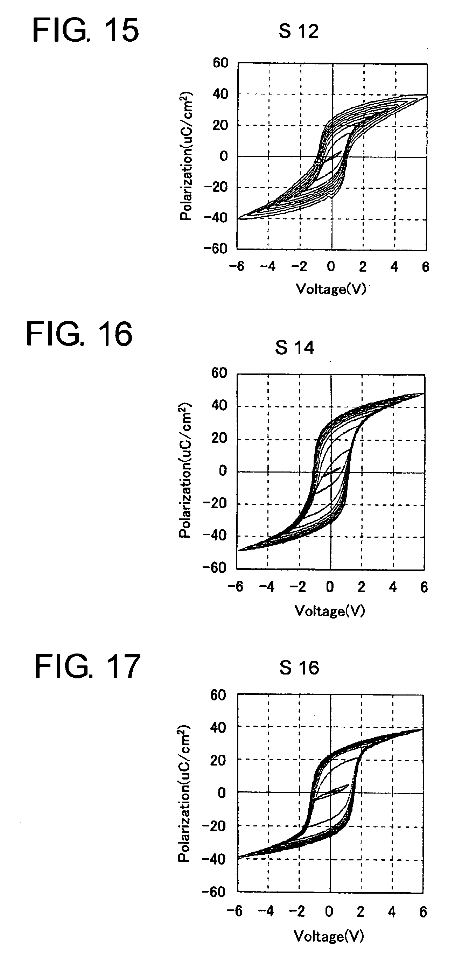

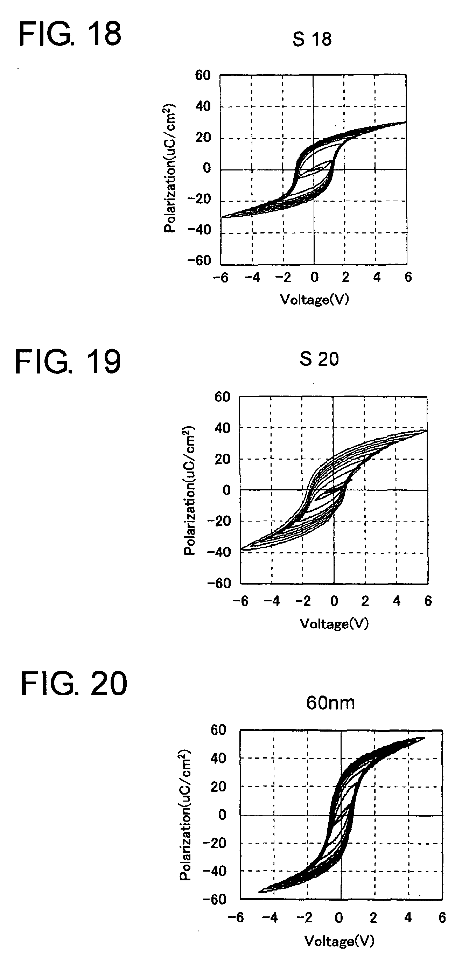

Hysteresis characteristics of the thin films having a film thickness of 240 nm thus manufactured were evaluated. FIGS. 15 to 19 show the results. According to FIG. 15 to FIG. 19, the addition of Si in a perovskite structure ferroelectric improved the surface morphology, and suppressed the leakage current, and the best hysteresis curve was obtained when the amount of added Si was 16 mol%. Also, as shown in FIG. 18 and FIG. 19, when the amount of added Si exceeded 18 mol%, an electric filed cannot be sufficiently applied to the ferroelectric portion due to the influence of SiO₂ that appeared at the interface, and as a result, it was observed that there was a tendency to the remanence value in the hysteresis characteristic becoming smaller. In other words, it was confirmed that the optimum amount of silicate added to a perovskite structure ferroelectric represented by ABO₃ such as PT was 16 mol%. It is noted that the amount of 16 mol% of added Si converted to atom % (at %), corresponds to 13.7 at%, and it was confirmed that Si entirely replaced the A site as Si²⁺. Furthermore, when the amount of added Si was 16 mol%, an excellent hysteresis characteristic was obtained because the leakage current density was suppressed.

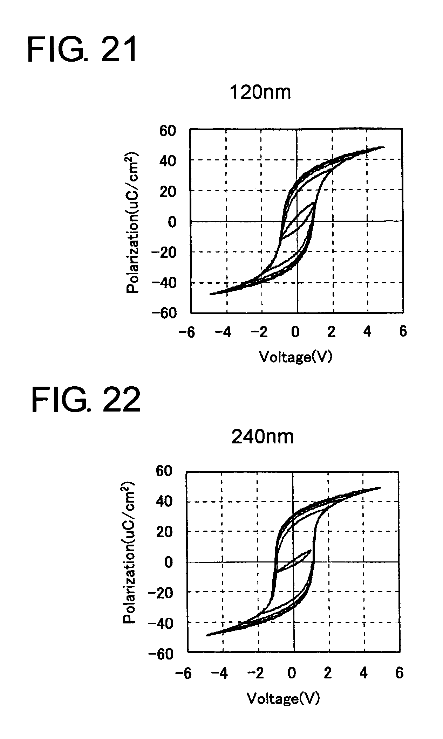

Accordingly, thereafter, the amount of added Si was fixed at 13.7 at%, and PT films were formed while changing the film thickness of the PT films, and the possibility of further thinning ferroelectric films was examined. Hysteresis characteristics of the films obtained are shown in FIG. 20 to FIG. 22. FIG. 20 shows the case when the film thickness is 60 nm, FIG. 21 shows the case when the film thickness is 120 nm, and FIG. 22 shows the case when the film thickness is 240 nm. It was found, according to FIG. 20 to FIG. 22, that an excellent hysteresis was obtained when the film thickness was in the range between 60 nm and 240 nm, and the addition of Si to PT was effective in improving the leakage characteristics.

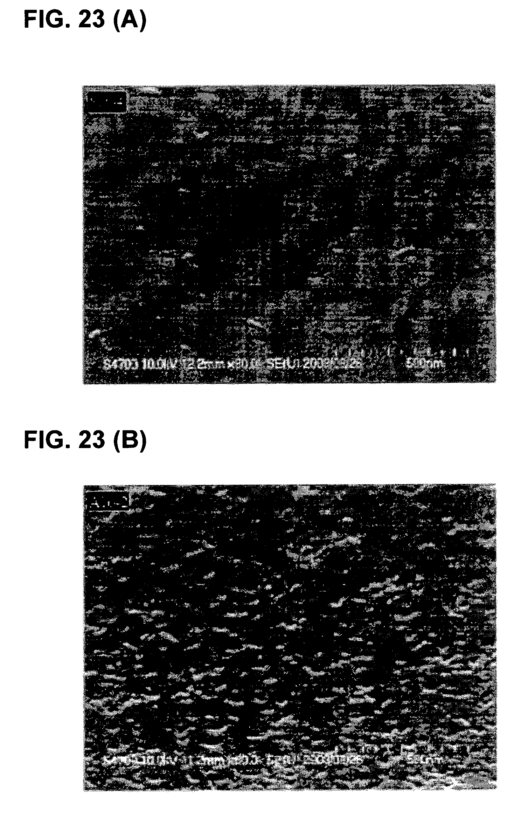

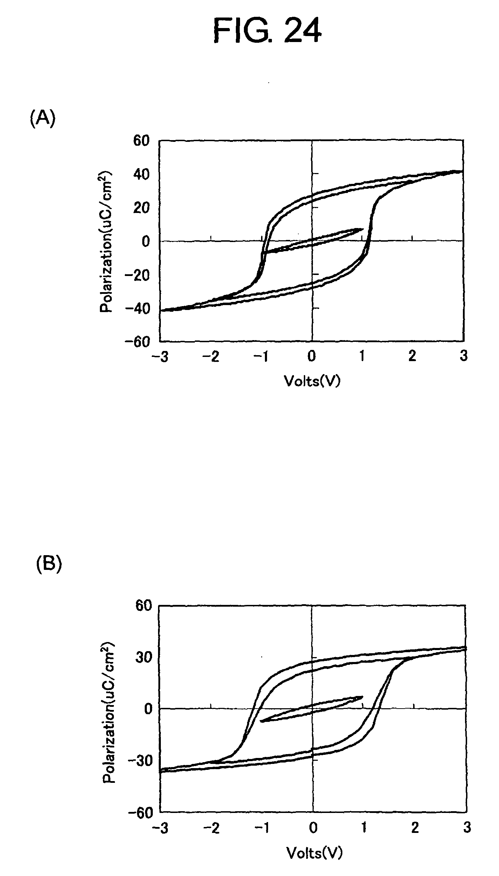

Next, by using the amount of added Si of 13.7 at% (16 mol%) that was obtained in the experiments conducted on the PT films, Si was added to PZT that was a perovskite structure ferroelectric represented by ABO₃ like PT. Surface morphologies of the PZT films obtained in this instance are shown in FIGS. 23 (A) and (B). FIG. 23 (A) shows a surface morphology of the PZT film when the Zr/Ti ratio is 30/70, and FIG. 23 (B) shows a surface morphology of the PZT film when the Zr/Ti ratio is 20/80. Also, hysteresis characteristics of the PZT films obtained in this instance are shown in FIGS. 24 (A) and (B). FIG. 24 (A) shows a hysteresis characteristic of the PZT film when the Zr/Ti ratio is 30/70, and FIG. 24 (B) shows a hysteresis characteristic of the PZT film when the Zr/Ti ratio is 20/80. According to FIGS. 23 and FIG. 24, it was confirmed that excellent surface morphologies and hysteresis characteristics were also obtained with PZT films.

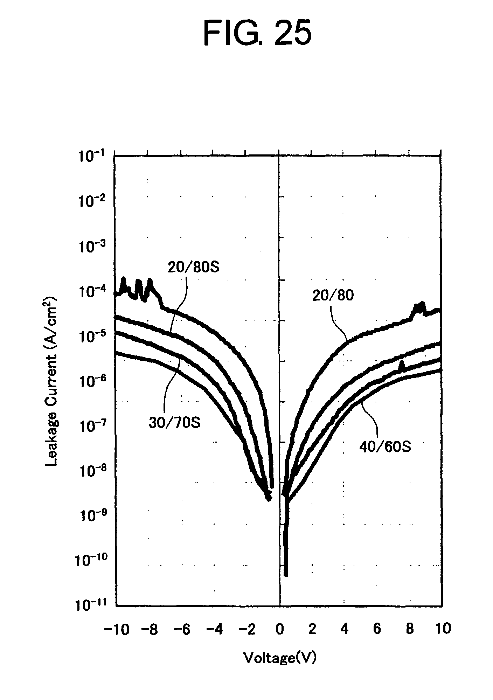

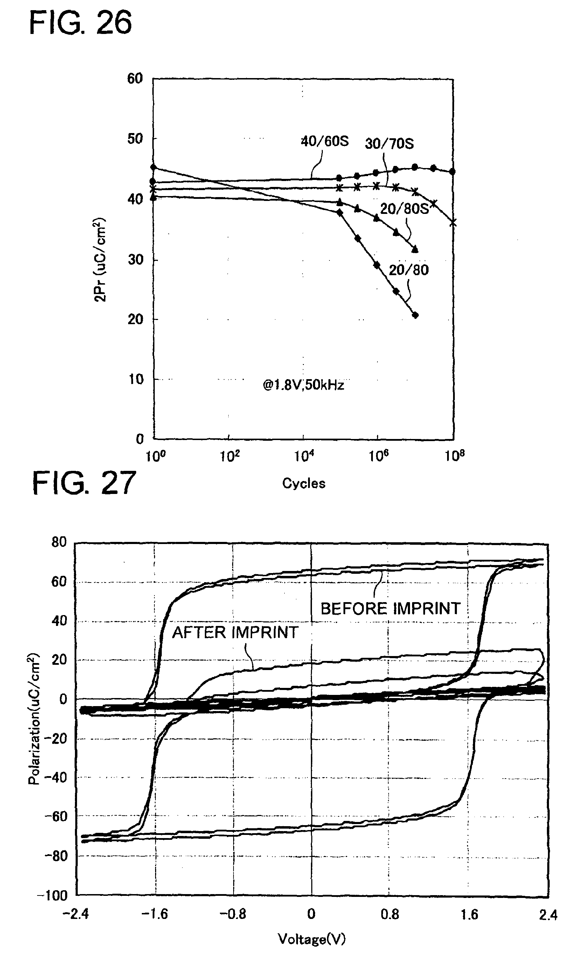

The reliability (leakage current characteristics, fatigue characteristics, and static imprint characteristics) of PZT films in which 16 mol% (13.7 at%) of Si was added to the stoichiometric composition was evaluated, and FIGS. 25 to 27 show the results. FIG. 25 shows the leakage current characteristics, FIG. 26 shows the fatigue characteristics, and FIG. 27 shows the static imprint characteristics. According to FIGS. 25 to 27, the PZT films of the present example indicated a very poor reliability. For example, in the case of the leakage current characteristics, about a 10-fold reduction was observed in the leakage current, compared to the case where Si was not added, but it was found that the leakage current increased with an increase in the content of Ti, and the leakage current reduction effect achieved by the addition of Si was not sufficient. Similarly, in the case of fatigue characteristics, a slight improvement was observed in the fatigue characteristics by the addition of Si, which was insufficient. In particular, in the case of the static imprint characteristics, no effect was observed.

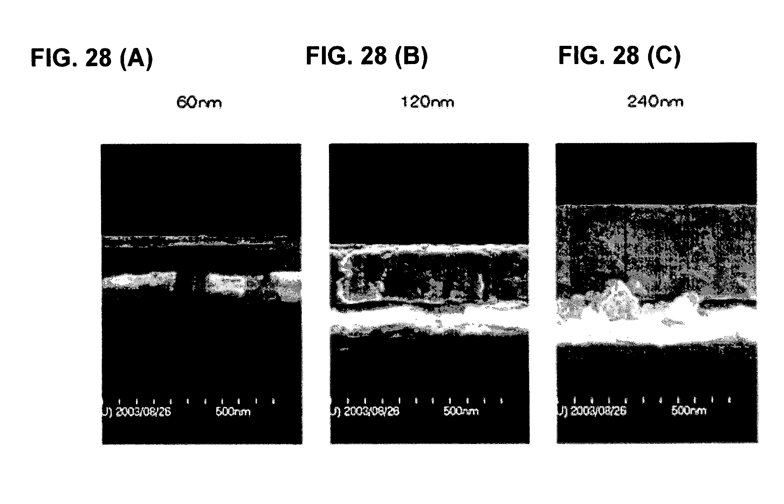

Then, SEM cross-sectional images of the PZT films in accordance with the present example were observed, and the results shown in FIG. 28 (A) to FIG. 28 (C) were obtained. As shown in FIG. 28 (A) to FIG. 28 (C), it was found that the PZT films with Si added had a granular structure, not a columnar structure that is observed in ordinary PZT films. For this reason, this provided a structure in which many capacitors are connected in series in the direction of electric filed. As a result, although some effects were observed in the leakage current characteristics, it is assumed that the presence of many grain boundaries caused a space charge polarization, which lead to the deterioration in the fatigue characteristics and imprint characteristics.

In view of the above, it was confirmed that the addition of silicate in Ti-rich tetragonal PZT exhibited a slight improvement in the leakage current characteristics, but did not improve the fatigue characteristics or the imprint characteristics that greatly influence the reliability of FeRAMs, and further improvement measures would be necessary.

### Example 2

It was found from Example 1 that the effect achieved by the addition of Si in Ti-rich PZT was not enough to secure the reliability of devices. However, in order to achieve a higher integration of ferroelectric memories, Ti-rich tetragonal crystal thin films (tetragonal crystal thin films) need to be used. In other words, by making the films Ti-rich, the squareness of the hysteresis improves and the coercive electric field becomes larger, such that thin films resistive to noise can be designed. Furthermore, since the relative dielectric constant lowers from about 1500 to about 300, high-speed operations become possible.

Therefore, in accordance with the present example, we proved that both excellent hysteresis and high reliability could be established concurrently by using ions added to the B site of a perovskite structure ferroelectric represented by ABO₃ in accordance with the present invention based on tetragonal (tetragonal crystal) PZT.

First, the problem entailed by PZT-based ferromagnetic materials is that, conventionally, the leakage current density of PZT was not conceived as a problem. This is because a pulsed electric field of several MHz or higher is used in reading data, such that influences of leakage currents can be ignored. However, if it is assumed that the leakage current density increases for a cause existing inside PZT material itself, an increase in the leakage current density can pose a significant problem to ferroelectric materials. Accordingly, the inventors of the present invention attempted to reduce the leakage current of tetragonal PZT.

First, as to the cause of an increase in the leakage current density, because PZT-based ferroelectric materials are intrinsically leaky, as described above, they have more leakage when the content of Ti is increased. Next, if the leakage is assumed to be caused by an oxygen vacancy, it can be assumed that, because oxygen ions are always present next to positive ions in a perovskite structure, a positive ion defect becomes a fixed charge, and would not easily move. On the other hand, because oxygen ions are connected from top to bottom because of the structure of perovskite crystal, it is assumed that an oxygen defect can contribute to the leakage current. Also, it is known that a PZT-based ferroelectric material generally has a higher leakage current density compared to a Bi- layered-structured ferroelectric material, and its leakage current density becomes higher when Ti is increased. In view of the above, it can be assumed that Pb and Ti may be the cause of an increase in the leakage current.
Accordingly, a variety of physical values of each of the PZT constituent elements is summarized and shown in Table 2.

**Table 2**

| Name | Atomic Weight | Valence value | Atomic Radius | Binding Energy | Ionization Potential |
|---|---|---|---|---|---|
| | | (Ionic radius (Å)) | (Å) | M-O (kcal/mol) | (eV) |
| Pb | 207.2 | +2 (1.08), +4 (0.78) | 1.33 | 38.8 | 7.416 |
| Zr | 91.224 | +4 (0.72) | 1.6 | 185 | 6.84 |
| Ti | 47.88 | +2 (0.86), +3, +4 (0.61) | 1.47 | 73 | 6.82 |
| Nb | 92.906 | +3, +4, +5 (0.64) | 1.47 | 177 - 189 | 6.88 |
| O | 54.36 | -1, -2 (1.4) | 0.61 | 119 | 13.618 |

It is known that lead has a high vapor pressure, and becomes to be vapor at about 150 °C to start its vaporization, and it is understood from Table 2 that its bonding energy with oxygen is very small, which is 39 kcal/mol. In other words, when crystallization heat treatments are conducted at 700 °C or lower to crystallize PZT, in general, it is assumed that the heat energy applied in the crystallization heat treatment breaks Pb-O bonds, thereby generating Pb defects. Then, as a result of the Pb defects being generated, oxygen vacancies occur according to the principle of charge neutralization.

On the other hand, it can be observed from Table 2 that Ti is the lightest element with its atomic weight being 47.87 among PZT constituent elements. It is noted here that each of the atoms constituting the crystal always rotates and is subjected to repeated collisions. In other words, each of the atoms always vibrates, rotates and is subjected to repeated mutual collisions, according to the environment in which that atom exists, in particular, according to the temperature. The atoms undergo repeated collisions violently even much more, when a crystallization heat treatment is conducted. At this time, the lightest Ti would most likely receive the influence of the collisions. In other words, it is assumed that Ti also generates a defect easily, like Pb. Therefore, there is a possibility that the Ti-O bonds are cut by the thermal energy added at the time of crystallization heat treatment, thereby creating Ti defects. If an oxygen vacancy is caused by the principle of charge neutralization when the Ti defect is generated, a Schottky defect (a defect that is generated by a pair of a positive ion and a negative ion formed) is readily generated in a so-called tetragonal PZT, and it is assumed that the leakage current density increases due to the Schottky defect.

If the model of the increase of leakage current density of tetragonal PZT so far described is true, the solution of these problems is difficult with pure PZT. It is considered from Table 2 that it is very difficult to control evaporation and defects of Pb. Then, while allowing Pb defects to occur, it can be said that it would be acceptable if the leakage current density does not increase, even when the Pb defects occur if oxygen vacancies do not occur.

Accordingly, doping of Nb ions in the B site where Ti ions exist was attempted on a perovskite structure ferroelectric material represented by ABO₃ in the present embodiment. In other words, by partially replacing Ti ions in the B site with Nb ions that may form defects just as does Pb, the content of Ti itself can be reduced.

Next, the reason why Nb ions were selected as ions to be added to the B site is described. Because an Nb atom has generally the same size as that of Ti, and just twice its weight, the influence of atomic collisions is small. In addition, it is easier for a smaller Nb atom to enter than an oxygen atom having a larger size to cause a defect in terms of energy. Also, because Nb has a stable valence at +5, it has an excess valence of +1 with respect to Ti whose valence is +4. In accordance with the present invention, one of the features is to prevent an oxygen ion vacancy (a valence of -2) with the excess valence of +1. In other words, by replacing a Ti ion with two Nb ions to thereby prevent one oxygen ion vacancy, the charge neutralization is established. In addition, according to first-principles simulation, the covalence of Nb with oxygen is extremely strong, such that replacing Nb at the B site makes oxygen difficult to generate defects *(Document 1:* Miyazawa, E. Natori, S. Miyashita, T. Shimoda, F. Ishii and T. Oguchi; Jpn. J. Appl. Phys. 39 5679 (2000)).

It is noted that the Nb doping into PZT has been attempted. However, it is reported that the Nb doping is extremely difficult in most of the cases *(Document 2*: T. Matsuzaki and H. Funakubo, J. Appl. Phys. 86, 4559 (1999), and *Document 3*: G. Bums and B. A. Scott, Phys. Rev. Lett., 25, 1191 (1970)).

As a typical example, although there has been a report that when the Ti ion in PbTiO₃ (PT) was replaced with the Nb ion by 2.3 at% by using a vapor phase deposition (MOCVD) method, a single perovskite layer was obtained, a large characteristic change has not been reported. According to the conventional idea, the reason of adding Nb is to offset the Pb deficiency generated in PZT by the excess valance of Nb. However, the leakage current increase cannot be explained if the Pb deficiency is considered to be a fixed charge. Furthermore, the above *Document 3* reports that an addition 5 at% Nb resulted in an ordinary paraelectric pyrochlore phase, which indicates the difficulty of the Nb doping.

In the present example, the examination was conducted based on PZT (Zr/Ti = 20/80), and PZT manufactured under the conditions used in the present example suggests oxygen vacancies of 10 at% or more. In other words, if the PT reported in *Document 3* had oxygen vacancies in an amount equal to that of the PZT examined in the present example, it is assumed the addition of 2.3 at% Nb was hardly effective, which merely improved the oxygen vacancies equal to half the amount of added Nb, that is about 1.15 at%. Also, a MOCVD method is a method to obtain a solid phase directly from a vapor phase, and is accompanied by a great energy change which takes place with the change of state from a vapor to solid state. Therefore, although this is an advantageous film forming method in terms of the effect of lowering the crystallization temperature, the fact that pyrochlore that is a low-temperature phase was obtained means that the crystallization temperature of PZT considerably elevated due to the Nb doping.

If PZT contains oxygen vacancies of about 10 at% or more, Nb doping in the amount of about 20 at% is needed to possibly achieve the Nb replacing effect to prevent the oxygen vacancies in PZT. However, on the other hand, reduction of the crystallization temperature must be conducted at the same time. Accordingly, as indicated by Example 1 in accordance with the present embodiment, in which the A site is replaced with Si, even a very small amount thereof improved the surface morphology to be dense and smooth.

Based on the examination results, in accordance with the present example, a large amount of Si to the extent of destroying the columnar structure of PZT was not added, but a very small amount of Si of a concentration of 5 at% or lower was added at the same time with the Nb doping. Conditions shown in Table 3 were used to form PZTN films.

**Table 3**

| Manufacturing conditions | |
|---|---|
| Composition | PZT (Pb/Zr/Ti = 110/X/100-X) + 20%PbNb (Pb/Nb = 110/100) + 1 ~ 3 %Si X= 2.5 ~ 40 mol% |
| Rotation speed | 2000 - 5000 rpm |
| Heat treatment | 700 °C |

| Sintering condition | |
|---|---|
| Lower electrode | Pt//TiOₓ /SiO₂/ Si |
| Coating | 2000 ~ 5000 rmp, 30 sec. |
| Drying + Sintering | 150 °C, 2 min. + 300 °C, 4 min. |
| Crystallization | 700 °C, 5 min., O₂, 50 °C/sec. |
| Upper electrode | Pt |
| Post Annealing | 700 °C, 15 min., O₂, 50 °C/sec. |

In the present example, a PZTN (Pb/Zr/Ti/Nb = 110/20/60/20) film with a thickness of 200 nm was formed by using a spin coat method, with a sol-gel solution for forming PZT in which Nb and Si were added in advance, in an oxygen atmosphere at 650 - 800°C. It is noted that a ferroelectric film was formed on an electrode, and Pt was used as an electrode material.

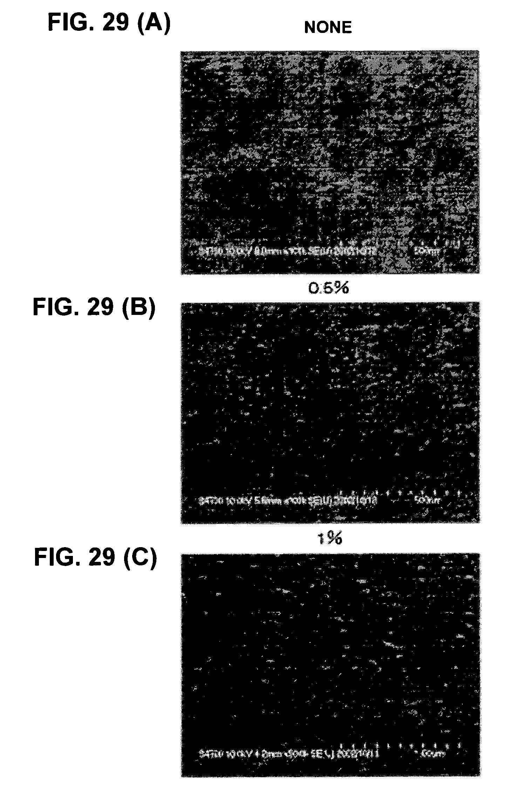

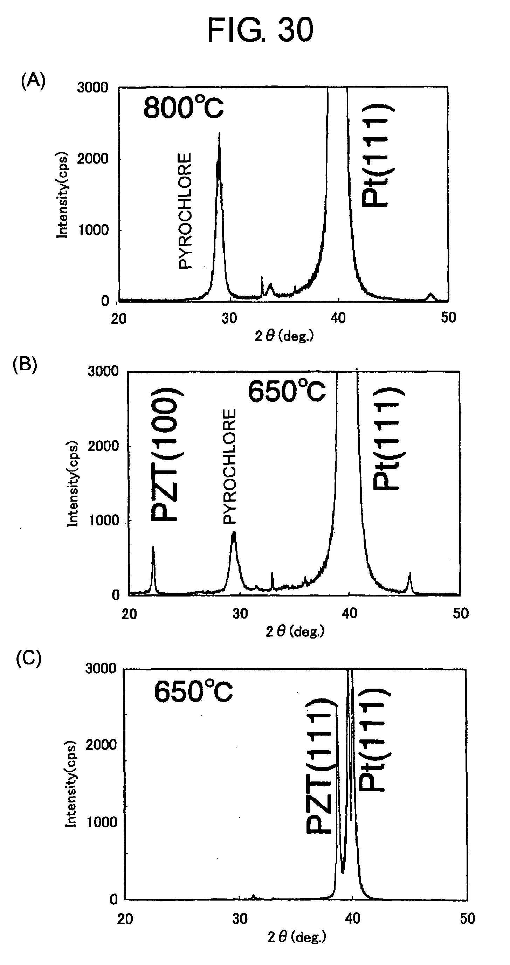

Surface morphologies of the ferroelectric films obtained are shown in FIGS. 29 (A) to 29 (C). Also, XRD patterns of the respective ferroelectric films are shown in FIGS. 30 (A) to 30 (C). When Si was not added at all (FIG. 29 (A), FIG. 30 (A)), a paraelectric pyrochlore phase alone existed even when sintering was attempted at a high temperature of 800°C. Next, when 0.5 mol% Si was added (FIG. 29 (B) and FIG. 30 (B)), and when the sintering temperature was 650°C, a reflection peak from a perovskite phase in addition to a paraelectric pyrochlore phase was observed. Further, when the amount of added Si was 1 mol% (FIG. 29 (C) and FIG. 30 (C)), when the sintering temperature was 650°C, a perovskite single layer was obtained, and the layer had an excellent surface morphology.

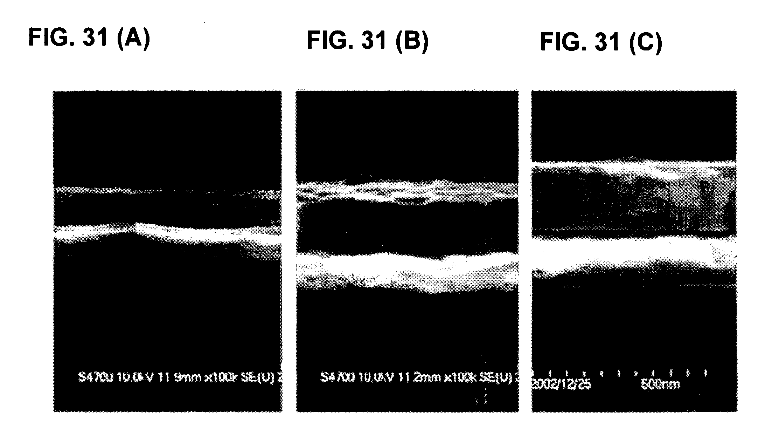

Also, as shown in SEM cross-sectional images in FIGS. 31 (A) to (C), the PZTN films obtained in accordance with the present example had a columnar structure, which is characteristic of a PZT-base ferroelectric film, and had a film structure substantially different from that of the PZT film with silicate added in Example 1.

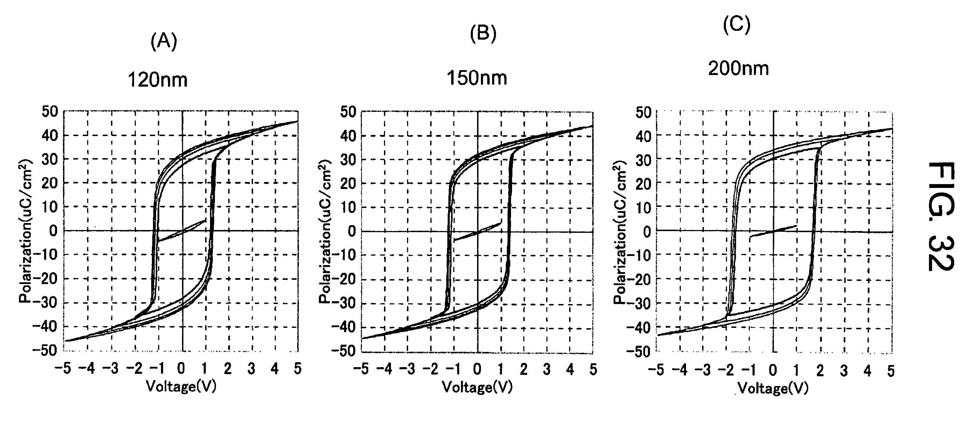

Further, a 100 µmφ - Pt upper electrode was formed on each 200 nm - PZTN film obtained in the present example, and their electrical characteristics were evaluated. As a result, P-E hysteresis characteristics having excellent squareness indicated in FIG. 32 (A) to FIG. 32 (C) were obtained. For example, in the case of the film thickness of 200 nm shown in FIG. 32 (C), the ferroelectric characteristics in which the polarization amount Pr was about 35 µC/cm², and the coercive electric field Ec was 80 kV/cm (because the polarization is 0 at the hysteresis being ± 1.6V, Ec = 1.6 V/200 nm = 80 kV/cm) were confirmed. It should be specifically noted that, although having a very good squareness and showing a large coercive electric field of about 80kV/cm, the ferroelectric hysteresis was almost saturated by application of an electric field of 100 kV/cm.

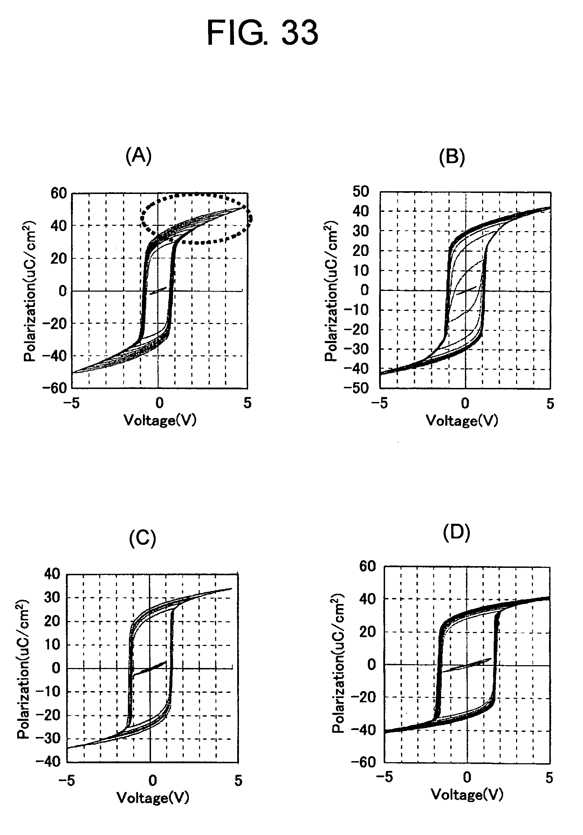

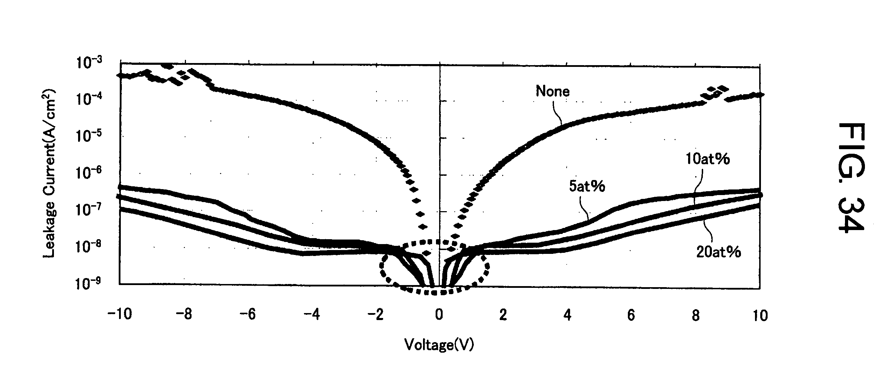

FIG. 33 (A) to FIG. 33 (D) are graphs showing the relation between the amount of added Nb and the hysteresis characteristics. FIG. 33 (A) shows the case when the amount of added Nb was 0 at%, FIG. 33 (B) shows the case when the amount of added Nb was 5 at%, FIG. 33 (C) shows the case when the amount of added Nb was 10 at%, and FIG. 33 (D) shows the case when the amount of added Nb was 20 at%. Also, FIG. 34 is a graph showing the relation between the amount of added Nb and the leakage characteristics. As shown in FIG. 33 (A), when the amount of added Nb was 0 at%, in other words, in the case of conventional PZT, the leakage characteristics were very poor, and as indicated by a region encircled with a dotted line in the graph, many leakage currents were included, such that the upper portion of the hysteresis bulges out. As shown in FIG. 34, when the amount of added Nb was 5 at%, the leakage characteristics were somewhat improved, but as indicated by a region encircled with a dotted line in the graph, there were still many ohmic current regions, which indicated that the improvement was not sufficient. Also, as shown in FIG. 33 (B), when the amount of added Nb was 5 at%, the squareness was not very good, and the saturation characteristics were not excellent either, such that it would be difficult to drive a device at a low voltage.

Also as shown in FIGS. 33 (C) and (D), when the amount of added Nb was 10 at% and 20 (at%), respectively, excellent hysteresis characteristics having excellent saturation characteristics and good squareness were obtained. Further, as shown in FIG. 34, the ohmic current regions in the leakage characteristics were greatly improved. Also, when the amount of added Nb was 20 at%, it can be observed from in FIG. 33 (D) that, because the B site ion replacement, which determines the ferroelectric characteristics, was high at 20 at%, the coercive voltage increased to around 1.6V, but saturated below 2V. This kind of saturation characteristics is the most significant characteristics of PZTN ferroelectric materials. The above indicates that, because PZT contains oxygen vacancies exceeding 10%, the amount of Nb to be added needs to be at least 10 at% and more preferably 20 at%.

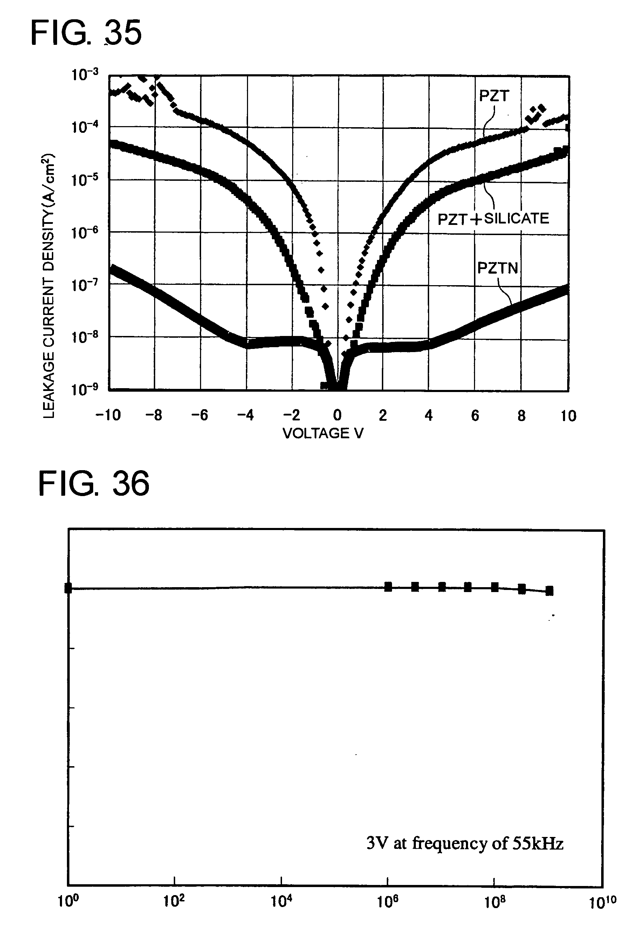

FIG. 35 is a graph showing the results of comparison of leakage current characteristics among PZT, PZT with 10 mol% Si added using PbSiO₃, and PZTN, each having a film thickness of 200 nm. According to FIG. 35, in the case of PZT, the leakage current density continues to increase with a rise of the applied voltage. However, PZTN has a region of a so-called Schottky emission current mechanism, where almost no increase in the leakage current density is observed in a low voltage region below 5V. Although some increase in the leakage current density is observed in a high voltage region at 5V or higher, the level of the leakage is lower than that of PZT. It is believed that, because of a difference in the density of oxygen vacancies between PZT and PZTN, PZT and PZTN have different voltages at which the leakage current mechanism shifts from the Schottky emission current mechanism to a mechanism where the leakage current increases. As a result, PZTN exhibited a 4-digit reduction of the leakage current density compared to PZT at voltages (1.8V - 3V) at which the thin films are used, and it was confirmed that PZTN had a level of insulation about 10000 times greater than that of PZT.

Next, the fatigue characteristics are shown in FIG. 36. Ferroelectric capacitors used for the measurement of the characteristics used Pt for both of their upper electrode and their lower electrode, and the characteristics purely as ferroelectric materials were compared. It is known that, when a Pt electrode is used, PZT generally deteriorates until its polarization is reduced to half at 10⁹ cycle load tests. In contrast, in the case of PZTN, the polarization scarcely deteriorates. Conventionally, it is known that PZT materials would readily get fatigued on a Pt electrode, but the results of the present example indicate that PZT did not get fatigued, but PZT having oxygen vacancies gets deteriorated. Accordingly, it is understood that the present invention concerns a completely new material, and not merely an improvement of PZT that has been existed so far.

Next, evaluation results of the imprint characteristics and data retention characteristics are described, and their measurement methods are performed according to *Document 4:* J. Lee, R. Ramesh, V. Karamidas, W. Warren, G. Pike and J. Evans., Appl. Phys. Lett., 66, 1337 (1995), and *Document 5*: A. M. Bratkovsky and A. P. Levanyuk. Phys. Rev. Lett., 84, 3177 (2000)

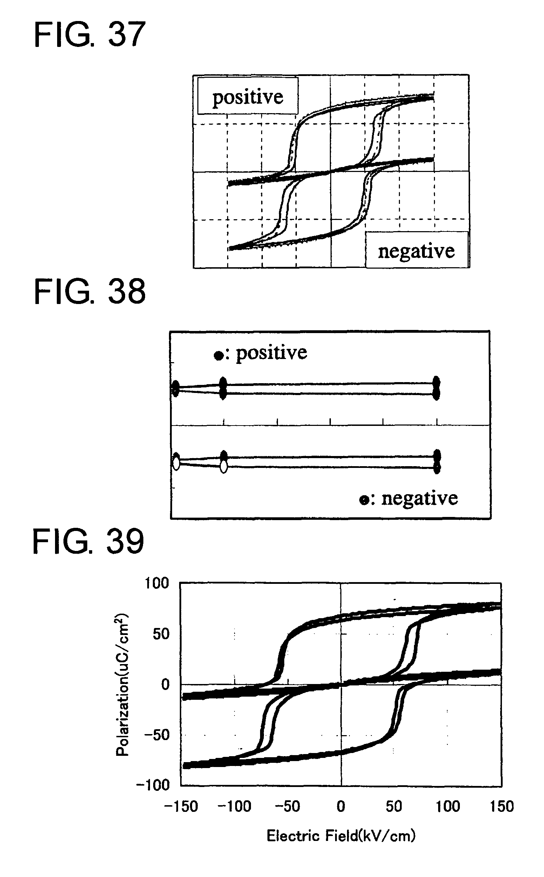

FIG. 37 shows results of evaluation tests of retention/static imprint characteristics obtained when data was retained at 125°C for 272 hours. FIG. 38 shows dynamic imprint characteristics obtained when imprinting of 10⁸ cycles were conducted under a constant temperature environment at 85°C. According to FIG. 38, it is confirmed that the shift amount of the hysteresis curve after the imprinting in the direction along a voltage axis is drastically reduced in PZTN, compared to that of a conventional PZT.

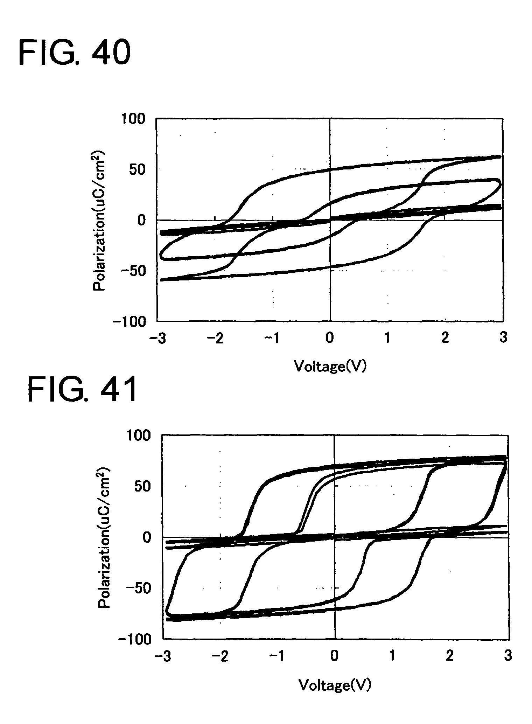

Next, evaluation tests on the static imprint characteristics were conducted under a high temperature environment at 150°C, and the results shown in FIG. 39 to FIG. 41 were obtained. FIG. 39 shows the result concerning a PZTN film ferroelectric film of the present example. FIG. 40 shows the result concerning a PZT (Zr/Ti = 20/80) film. FIG. 41 shows the result concerning a PZT (Zr/Ti = 30/70) film. In the case of the PZT, the polarization at the time of reading is lost by 40%, but in the case of the PZTN, the polarization at reading scarcely changes. The difference between the two derives mainly from the difference in the static imprint characteristics between the PZT and the PZTN. In other words, according to FIG. 39 to FIG. 41, it was confirmed that only the PZTN film shown in FIG. 39 had excellent imprint characteristics.

It is clear from the above that the PZTN has a very high reliability, compared to the PZT.

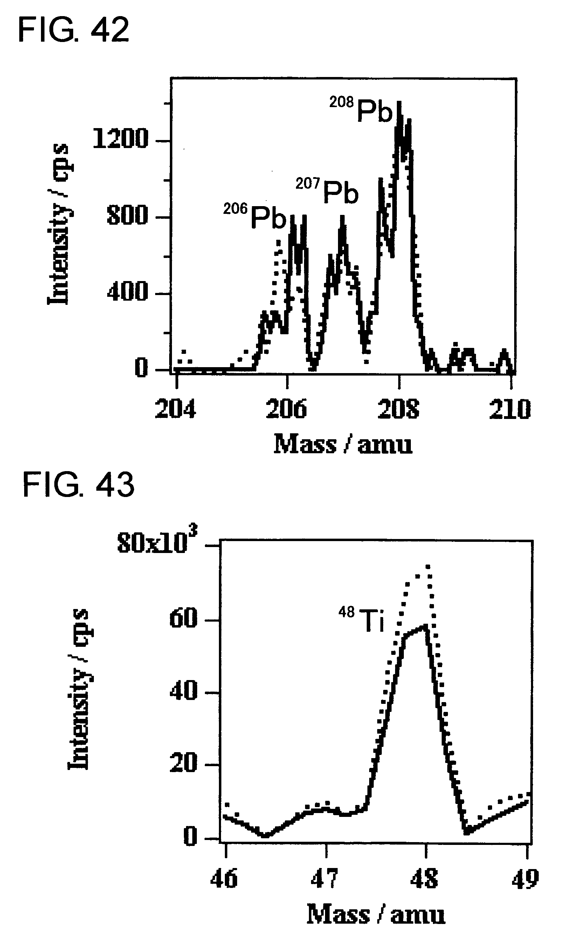

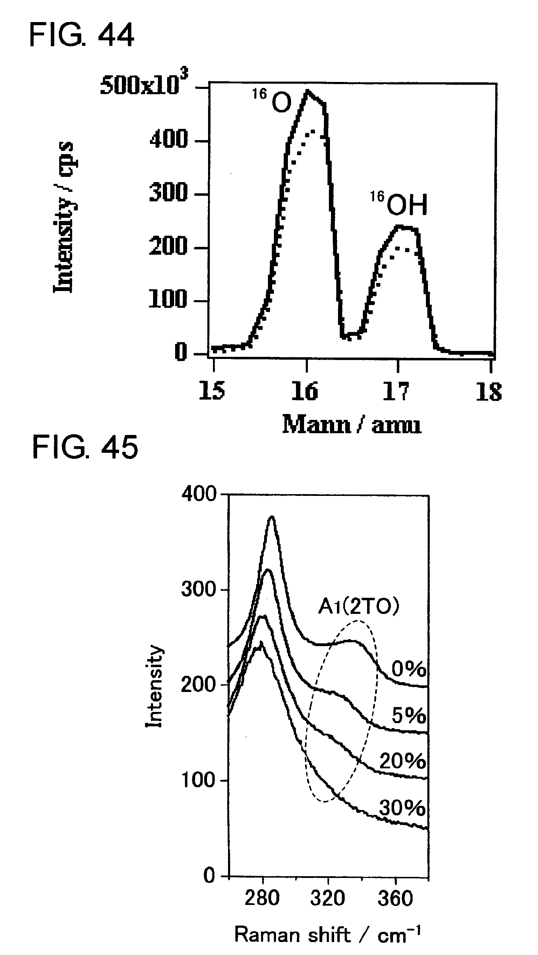

Next, in order to confirm if the high reliability of the PZTN material of the present example could be obtained because oxygen vacancies were prevented as assumed above, a variety of analyses were conducted. First, the amount of oxygen vacancies was examined by using secondary ion mass spectrometry (SIMS), and the results shown in FIG. 42 and FIG. 44 were obtained. A solid line in each of the figures indicates the case of the PZTN, and a broken line indicates the case of the PZT. As shown in FIG. 44, it was confirmed that the PZTN had an oxygen concentration that is about 10% higher than that of the PZT, and this is believed to prove the oxygen vacancy suppressing effect achieved by the addition of Nb. Also, as shown in FIG. 43, the Ti ion concentration is about 10% lower, compared to the PZT, and it was confirmed that the Ti content is lowered by the amount it is replaced with Nb.

Next, because SIMS does not provide high measuring sensitivity for Nb, the Nb concentration was measured by using an inductive coupling plasma emission method (ICP) and an X-ray photoelectron spectroscopy (XPS). As a result, as shown in Table 4 and Table 5, the Nb concentration for the B site in the PZTN was about 20 at%.

**Table 4**

| XPS | Unit | Pb-4f | Zr-3d | Ti-2p | Nb-3d | 0-1 s | Si-2p | Total |
|---|---|---|---|---|---|---|---|---|
| PZT | atomic% | 24.8 | 5.7 | 21.0 | - | 48.4 | 0.1 | 100 |
| PZTN | atomic% | 24.4 | 5.7 | 15.3 | 5.7 | 48.8 | 0.1 | 100 |

**Table 5**

| ICP | Unit | Pb | Zr | Ti | Nb | Total |
|---|---|---|---|---|---|---|
| PZT | µg | 351 | 26 | 58.5 | - | 435.5 |
| | atomic% | 53.0 | 8.9 | 38.1 | - | 100 |
| PZTN | µg | 391 | 34 | 54.2 | 33 | 512.2 |
| | atomic% | 50.3 | 9.8 | 30.3 | 9.6 | 100 |

Next, whether Nb replaced the B site was analyzed by Raman spectroscopy. Raman spectra of PTN (PbTi ₁₋ₓ NbₓO₃ : X = 0 ~ 0.3) obtained for different amounts of doping are shown in FIG. 45.

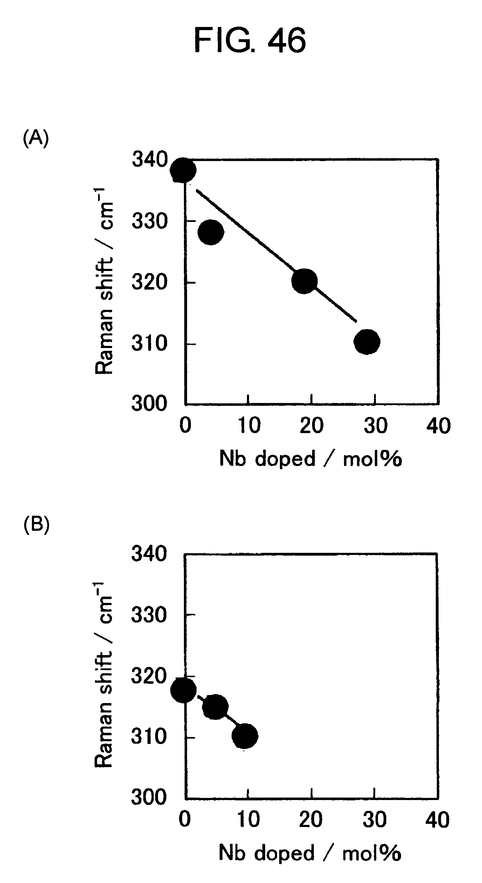

Peaks indicating vibrational modes originating from the B site ion called A₁(2TO) shown in FIG. 45 shift toward the lower wave number side with an increase in the Nb doping amount as indicated in FIG. 46 (A). This indicates that Nb replaces the B site. Further, in FIG. 46 (B) that indicates the case of PZTN (Pb Zr_{Y} Ti _{1-Y-X} Nbₓ O₃ : X = 0 ∼ 0.1), it can be confirmed that Nb replaces the B site. From the examination results described above, it was proved that the reason why the PZTN materials of this invention had various excellent characteristics was that Nb introduced by 20 at% in the B site in PZT prevented oxygen vacancies of 10 at%, compared to simple PZT. The reason why the addition of a very small amount of Si in the present example made a large amount of Nb doping possible, which was conventionally considered to be difficult, is believed that Si has not only the crystallization temperature lowering effect but also a function to form a solid solution with Nb.

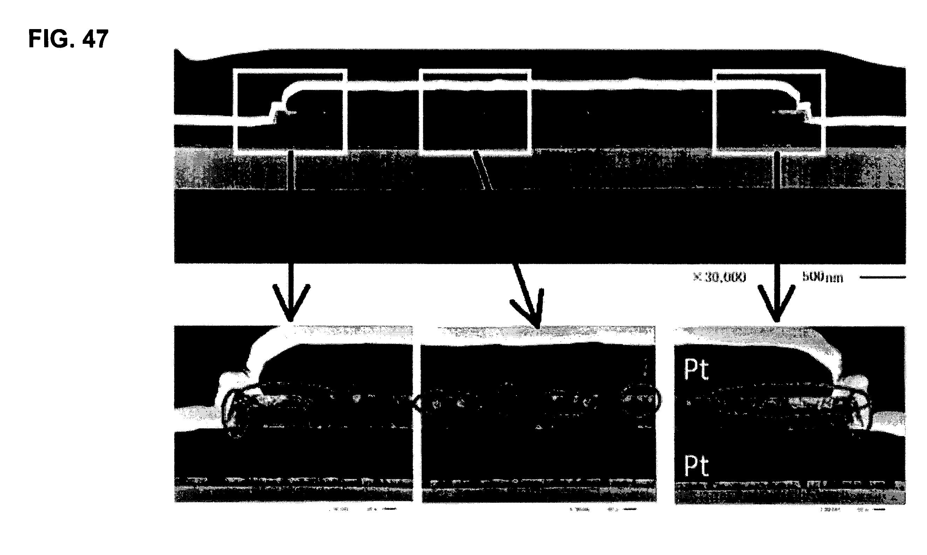

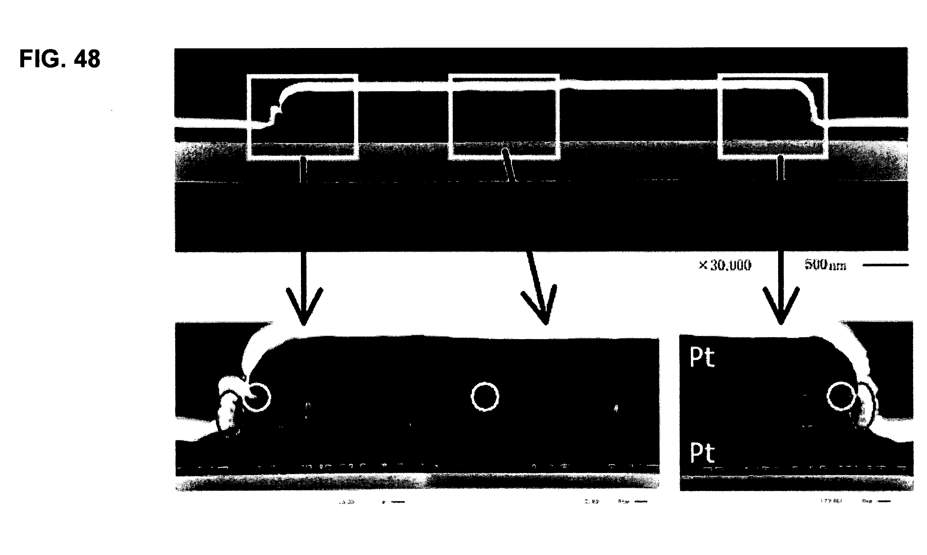

Next, TEM cross-sectional images of capacitors that were actually processed into a shape of 10 µm × 10 µm by dry etching are shown in FIGS. 47 and 48. FIG. 47 shows the result of observation of a PZT (Zr/Ti = 40/60)/Pt/TiOₓ capacitor. FIG. 48 shows the result of observation of a PZTN (Zr/Ti/Nb = 20/60/20)/Pt/TiOₓ capacitor. Both endmost portions of each of the PZT and PZTN capacitors that were cut by etching appear in white, which may indicate deteriorations. In the case of the PZT, it can be observed that the contrast appears in white in portions near the etching extending in a length of about 1 to 1.5 µm, and it can be observed that the contrast appears in white along the entire interface with the upper Pt electrode. Also, the film composition of these portions was measured, and it was confirmed that the Pb composition was substantially reduced in those portions. On the other hand, in the case of the PZTN, the contrast does not appear in white except for the two endmost portions that were processed. The composition of the portions adjacent to the endmost portions was analyzed, but no Pb escape was observed at all. At the same time, the composition of the central portion was also analyzed. Similarly, no Pb escape was observed at all. It is found from the above that the PZTN ferroelectrics in accordance with the present invention have a process damage resisting property to an extent that has never been thought of according to the common knowledge to date.

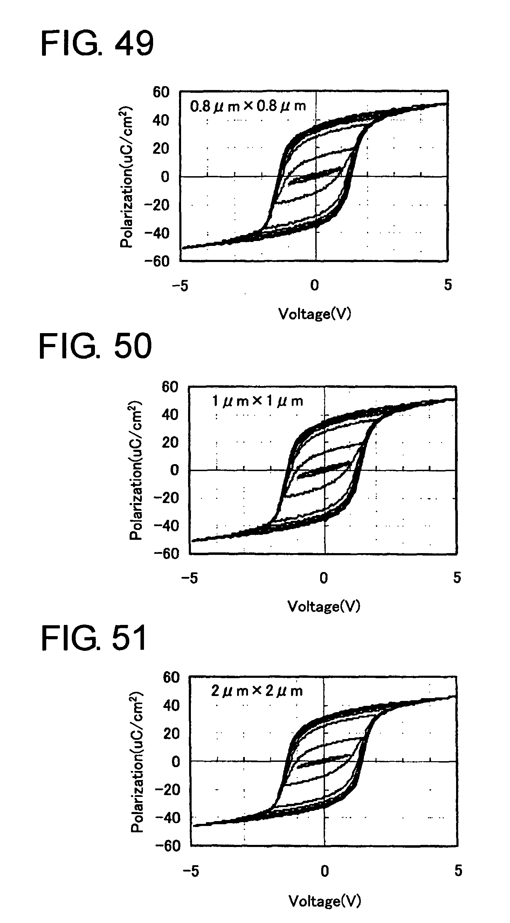

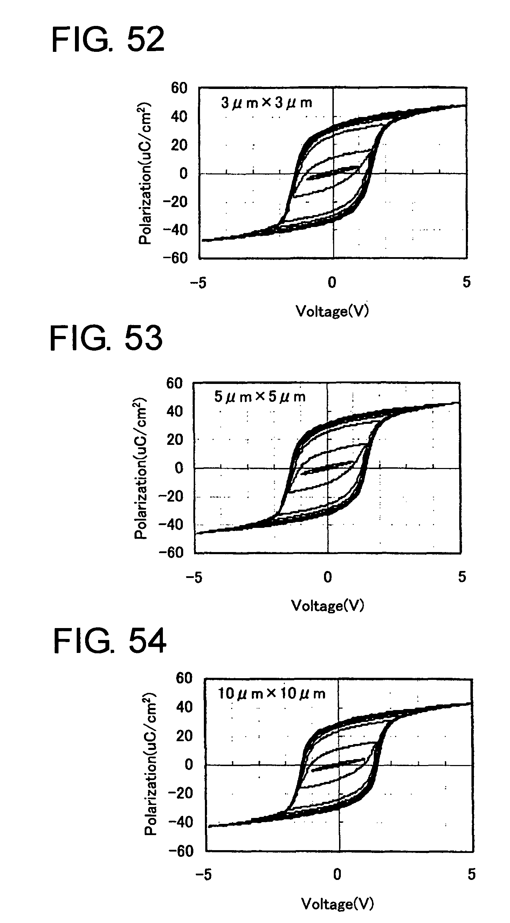

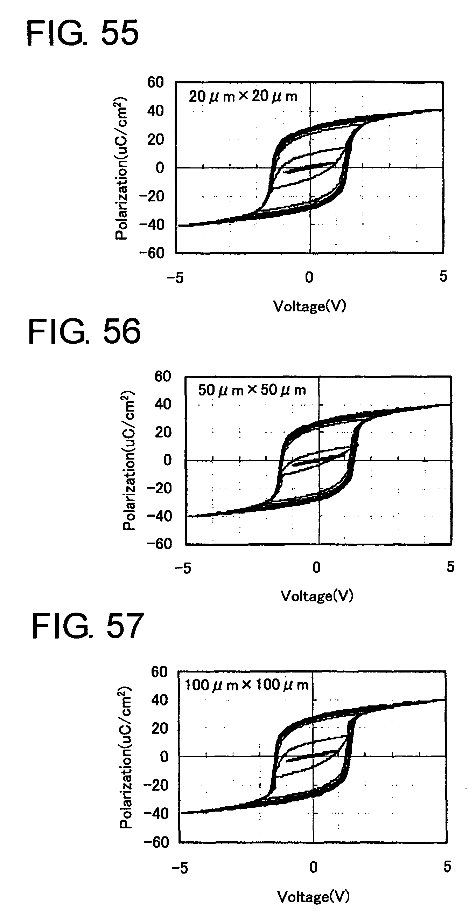

Then, hysteresis characteristics of capacitors that were processed into sizes of 0.8 µm × 0.8 µm to 100 µm × 100 µm, respectively, were evaluated, and as shown in FIG. 49 to FIG. 57, hysteresis characteristics that are hardly size-dependent were obtained. This also has never been thought of according to the common knowledge to date, and indicates the novelty of the PZTN in accordance with the present invention.

### Example 3

In the present example, the reason why Nb was particularly selected as a B site replacement material is described.

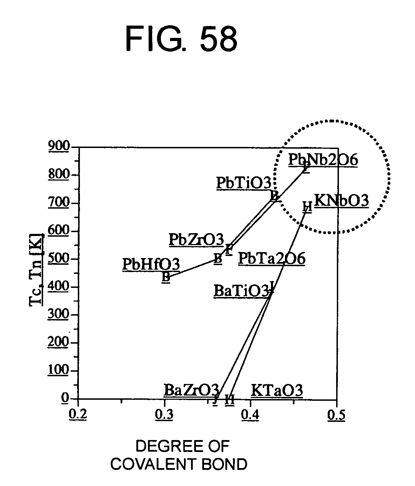

It is observed from the result of first-principles simulation in FIG. 58 that Nb and O have a strong covalent bond. In order to effectively prevent an oxygen vacancy, the strength of bonding with oxygen, in other words, the covalent bond is an important factor.

Therefore, in the present example, Ta, V and W were used, and substitutions of Nb were examined.

Because Ta and V have a valence of +5, PbZr_{0.2}Ti_{0.6}Ta_{0.2}O₃ and PbZr_{0.2}Ti_{0.6}V_{0.2}O₃ in which 20 at% Ti was replaced, like in the case of Nb, were manufactured. Because W has a valence of +6, PbZr_{0.2}Ti_{0.7}W_{0.1}O₃ in which 10 at% Ti was replaced was manufactured. The amount of excess Pb, sintering conditions, and the like were the same as the conditions shown in Table 3.

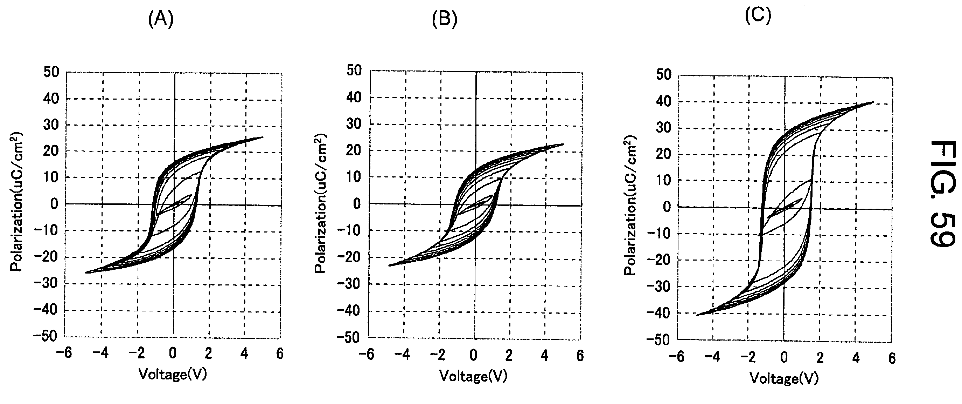

As a result, hysteresis characteristics shown in FIG. 59 (A) to FIG. 59 (C) were obtained. FIG. 59 (A) shows the case of PZTV (Zr/Ti/V = 20/60/20), FIG. 59 (B) shows the case of PZTW (Zr/Ti/W = 20/70/10), and FIG. 59 (C) shows the case of PZTTa (Zr/Ti/Ta = 20/60/20). In the case of V and W shown in FIGS. 59 (A) and (B), because of their weak covalent bond with oxygen, they exhibited hysteresis characteristics that are leaky and have insufficient squareness compared to Nb. On the other hand, in the case of Ta, under the sintering conditions of Table 3, almost no hysteresis opened. Then, when sintering at 850 °C was conducted, a relatively good hysteresis could be obtained as shown in FIG. 59 (C). However, due to the fact that it was not as good as that of Nb, and an elevation of the crystallization temperature greater than in the case of the Nb doping was observed, it was found that its application to devices would be difficult. From the above, the experimental results also proved the results of first-principles calculation shown in FIG. 58.

Next, the reason why the PZTN material had a high level of insulation was considered based on first-principles calculation. A transition metal oxide is essentially composed of ionic bonding crystal. However, the mechanism of manifestation of its ferroelectric property has been analyzed in detail from the viewpoint of first-principles calculation, and contribution from a covalent bond between the d-orbit of transfer metal and the 2p-orbit of nearest oxygen is important. The smaller the difference between the d-orbit energy of transfer metal in an atomic state and the 2p-orbit energy of oxygen, the stronger the covalent bond becomes, and the more the ferroelectric property becomes reinforced.

On the other hand, in a transition metal oxide composed of an ABO₃ perovskite-type structure, when Pb or Bi enters the A site, a new covalent bond is created between the 6p-orbit of Pb or Bi and the 2p-orbit of the nearest oxygen, such that the ferroelectric property of the system together with the covalence bonding of the B site transfer metal is enforced. This is considered to be the cause of why PZT and BIT have a high Curie temperature and a large polarization moment. Here, first-principles calculation is used to examine the relation between the electronic state of PZTN system and its high dielectric property. As its crystal structure, a (2 × 2 × 2) super cell is assumed.

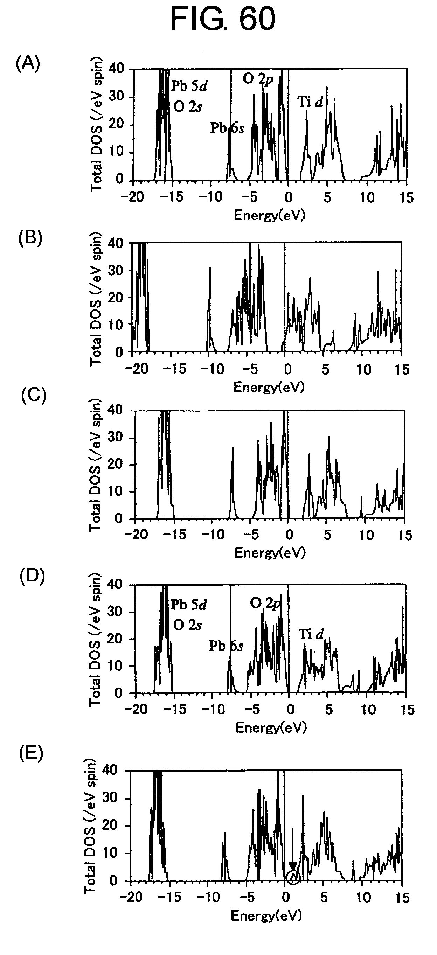

FIG. 60 (A) to FIG. 60 (E) show electronic density of states of PZT and PZTN systems. FIG. 60 (A) shows the density of states of Pb (Zr_{0.25}Ti_{0.75}) O₃ without vacancy. The top of the valence band consists of the 2p-orbit of oxygen. The bottom of the conduction band consists of the d-orbit of transfer metal, in particular, Ti. FIG. 60 (B) shows the case when Ti in the B site of PZT is replaced with Nb by 25%. From the position of the Fermi level, it can be observed that the conduction band is doped with electrons. The doping amount corresponds to an ionic image in which Nb provides 5 valence electrons, which is one more than that of Ti, to the system. FIG. 60 (C) shows the case when Pb of PZT is vacated by 12.5%. It can be observed that the valence band is similarly doped with holes. The amount of holes doped corresponds to the amount of valence electrons that are lost as a result of Pb acting as 2+ ions vacating from the system. FIG. 60 (D) shows the case when Ti in the B site is replaced with Nb by 25%, and at the same time, Pb is vacated by 12.5%. It can be observed that the doped electrons and holes are mutually cancelled out, such that the Fermi surface disappears, and the dielectric property is recovered. In comparing FIG. 28 (A) and FIG. 60 (D), the electronic structures near the band gap are similar to each other from the viewpoint of the density of states, and it can be considered that the operation in FIG. 60 (D) would not destroy the original electronic state of PZT (rigid-band changes).

In order for the system to maintain the dielectric property with respect to the amount δ of Nb replacement in the B site, a finite amount of Pb needs to be vacated, and the amount of vacancies must be δ/2. FIG. 60 (D) is considered to correspond to the electronic state of the PZTN system. On the other hand, FIG. 60 (E) shows the density of states when pairs of Pb and its adjacent oxygen in PZT are vacated by 12.5% (Schottky defects). Although the band gap is open, a state that can be considered as an impurity level appears at the bottom of the conduction band. For this reason, it can be observed that the band gap is substantially reduced compared to that shown in FIG. 60 (A). Compared to the band gap in FIG. 60 (A), the PZTN system shown in FIG. 60 (D) has a reduction in the band gap merely by 0.2 eV, but the one shown in FIG. 60 (E) with the same amount of Pb vacancies has a reduction in the band gap by nearly 1.2 eV. The substantial reduction of the band gap in FIG. 60 (E) is literally caused by the oxygen vacancies. This happens because the electrostatic potential that the d-orbit of transfer metal senses is lowered because intrinsically adjacent oxygen electronic clouds are lost due to the oxygen vacancies. The dielectric property of the system is determined by the size of the band offset. However, that dielectric substance has a broad band gap is a requisition to be a good dielectric substance. Accordingly, the reason why the PZTN system has a high level of dielectric property is believed to be caused by the fact that there are few oxygen vacancies and the reduction of the band gap is small. Furthermore, it is predicted that the reason why conventional PZT has a poor dielectric property is because many Pb-O Schottky defects exist instead of a stoichiometric composition, and thus the band gap decreases as in the case of FIG. 60 (E), causing a reduction of the band offset at the electrode interface.

### Summary of Examples 1 to 3

By adding a very small amount of Si as little as about 1% together with addition of Nb, Nb could form a solid solution by 20 at% or greater in the B site of PZT. It was found that Si acts to have Nb form a solid solution.
It was found that PZTN thin films 100 nm - 200 nm thick exhibit hysteresis characteristics having good squareness, have a leakage current density of less than 10⁻⁸ A/cm², that is, a level of dielectric about 1000 - 10000 times greater than that of conventional films, and have excellent reliability.

The analysis of the film composition suggested that the oxygen vacancies were reduced by about 10% compared to mere PZT.

### 2. Ferroelectric Memory

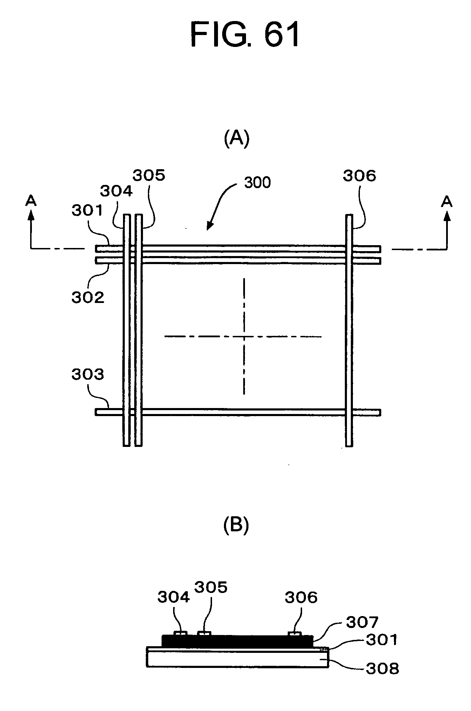

FIG. 61 (A) and FIG. 61 (B) are views showing a configuration of a simple matrix type ferroelectric memory device 300 in accordance with an embodiment of the present invention. FIG. 61 (A) is a plan view of the device, and FIG. 61 (B) is a cross-sectional view taken along line A - A shown in FIG. 61 (A). The ferroelectric memory device 300 includes, as shown in FIG. 61 (A) and FIG. 61 (B), a predetermined number of word lines 301 - 303 arranged and formed on a substrate 308, and a predetermined number of bit lines 304 - 306 arranged thereon. A ferroelectric film 307 composed of the PZTN described above in the present embodiment is interposed between the word lines 301 - 303 and the bit lines 304 - 306, wherein ferroelectric capacitors are formed in intersecting regions of the word lines 301 - 303 and the bit lines 304 - 306.

In the ferroelectric memory device 300 in which memory cells are arranged in a simple matrix, writing in and reading from the ferroelectric capacitors formed in the intersecting regions of the word lines 301 - 303 and the bit lines 304 - 306 are performed by a peripheral driver circuit, reading amplifier circuit, and the like (not shown) (which are hereinafter called "peripheral circuit"). The peripheral circuit may be formed by MOS transistors on a substrate different from that of the memory cell array and connected with the word lines 301 - 303 and the bit lines 304 - 306, or by using single crystal silicon on the substrate 308, the peripheral circuit may be integrated on the same substrate with the memory cell array.

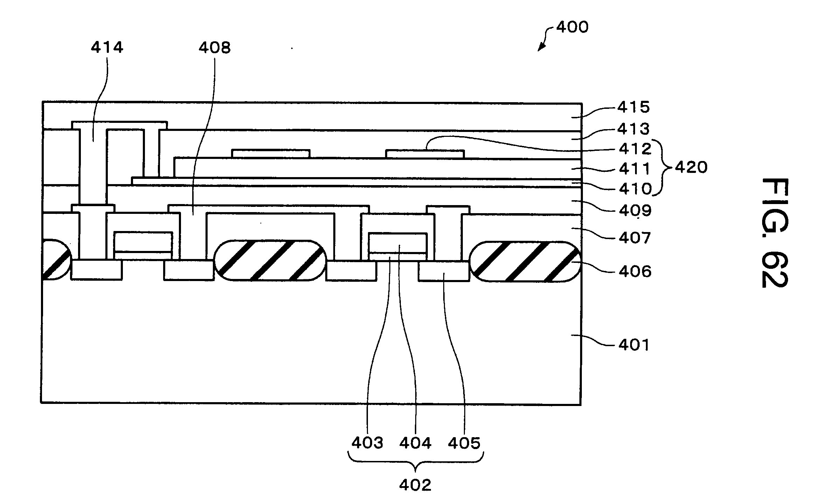

FIG. 62 is a cross-sectional view showing an example of a ferroelectric memory device 400 in accordance with the present embodiment in which a memory cell array is integrated with a peripheral circuit on the same substrate.

Referring to FIG. 62, MOS transistors 402 are formed on a single crystal silicon substrate 401, and the region where the transistors are formed defines a peripheral circuit section. The MOS transistor 402 is composed of a single crystal silicon substrate 401, a source/drain region 405, a gate dielectric film 403, and a gate electrode 404.

Also, the ferroelectric memory device 400 has an element isolation oxide film 406, a first interlayer dielectric film 407, a first wiring layer 408, and a second interlayer dielectric film 409.

The ferroelectric memory device 400 has a memory cell array composed of ferroelectric capacitors 420, and each of the ferroelectric capacitors 420 is composed of a lower electrode (first electrode or second electrode) 410 that defines a word line or a bit line, a ferroelectric film 411 including a ferroelectric phase and a paraelectric phase, and an upper electrode (second electrode or first electrode) 412 that is formed on the ferroelectric film 411 and defines a bit line or a word line.

Furthermore, the ferroelectric memory device 400 has a third interlayer dielectric film 413 over the ferroelectric capacitor 420, and a second wiring layer 414 connects the memory cell array and the peripheral circuit section. It is noted that, in the ferroelectric memory device 400, a protection film 415 is formed over the third interlayer dielectric film 413 and the second wiring layer 414.

According to the ferroelectric memory device 400 having the structure described above, the memory cell array and the peripheral circuit section can be integrated on the same substrate. It is noted that, although the ferroelectric memory device 400 shown in FIG. 62 has a structure in which the memory cell array is formed over the peripheral circuit section, it may have a structure in which the memory cell array is not disposed over the peripheral circuit section, and may be in contact with the peripheral circuit section in a plane.

Because the ferroelectric capacitor 420 used in the present embodiment is formed from the PZTN in accordance with the present embodiment described above, its hysteresis has excellent squareness, and its disturbance characteristics are stable. Moreover, damage to the peripheral circuit and other elements is reduced due to the lowered process temperature, and process damage (reduction by hydrogen, in particular) is small, such that the ferroelectric capacitor 420 can suppress deterioration of the hysteresis that may be caused by such damages. Therefore, the simple matrix type ferroelectric memory device 300 can be put in practical use by using the ferroelectric capacitor 420.

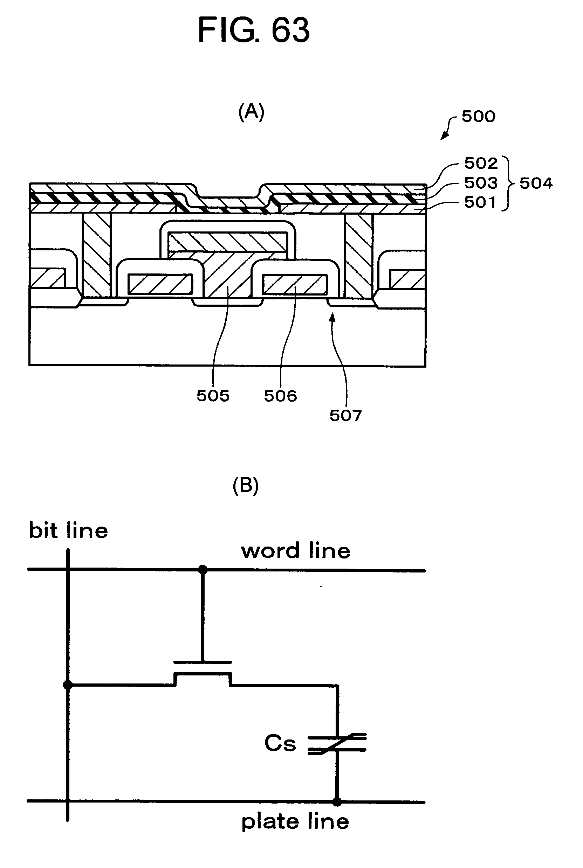

FIG. 63 (A) shows a structural drawing of a 1T1C type ferroelectric memory device 500 as a modified example. FIG. 63 (A) is an equivalent circuit diagram of the ferroelectric memory device 500.

As shown in FIGS. 63 (A) and (B), the ferroelectric memory device 500 is a memory element having a structure similar to that of a DRAM, which is composed of a capacitor 504 (1C) comprising a lower electrode 501, an upper electrode 502 that is connected to a plate line, and a ferroelectric film 503 using a PZTN ferroelectric in accordance with the present embodiment, and a switching transistor element 507 (1T), having source/drain electrodes, one of them being connected to a data line 505, and a gate electrode 506 that is connected to a word line. The 1T1C type memory can perform writing and reading at high-speeds at 100 ns or less, and because written data is nonvolatile, it is promising as replacement of SRAM.

### 3. Piezoelectric Element and Ink-jet Recording Head

An ink-jet recording head in accordance with an embodiment of the present invention is described below in detail with reference to the accompanying drawings.

As an ink-jet recording head, in which a part of a pressure generating chamber communicating with a nozzle orifice that ejects ink droplets is formed from a vibration plate, this vibration plate is deformed by a piezoelectric element to pressurize ink in the pressure generating chamber, and ink droplets are ejected from the nozzle orifice, two types of recording heads are put into practical use. One of them uses a piezoelectric actuator of a longitudinal vibration mode, which expands and contracts in the axis direction of the piezoelectric element, and the other uses a piezoelectric actuator of a flexural vibration mode.

As the one that uses an actuator of a flexural vibration mode, there is a recording head in which an even piezoelectric material layer is formed over the entire surface of a vibration plate by a film deposition technology, the piezoelectric material layer is divided into shapes corresponding to the pressure generating chambers by a lithography method, and for each pressure generating chamber a piezoelectric element is formed so as to be independent of the others elements.

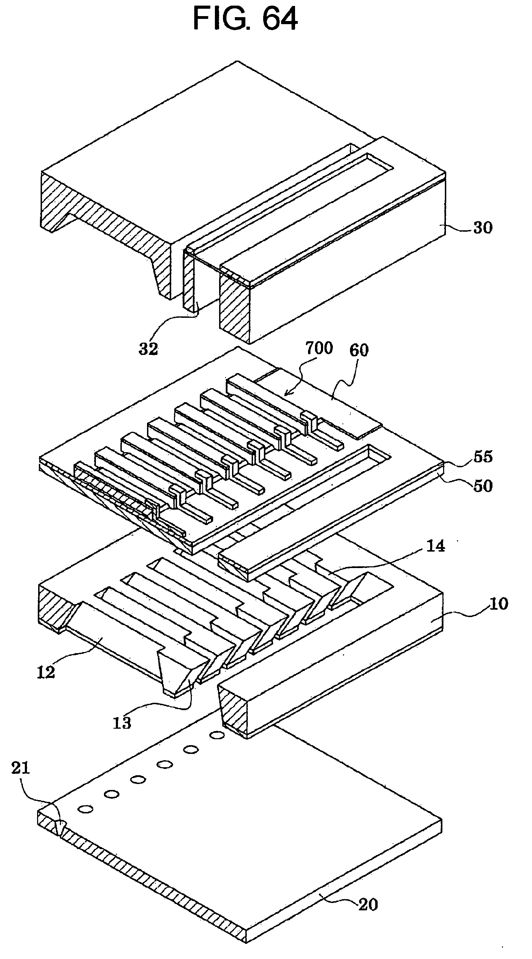

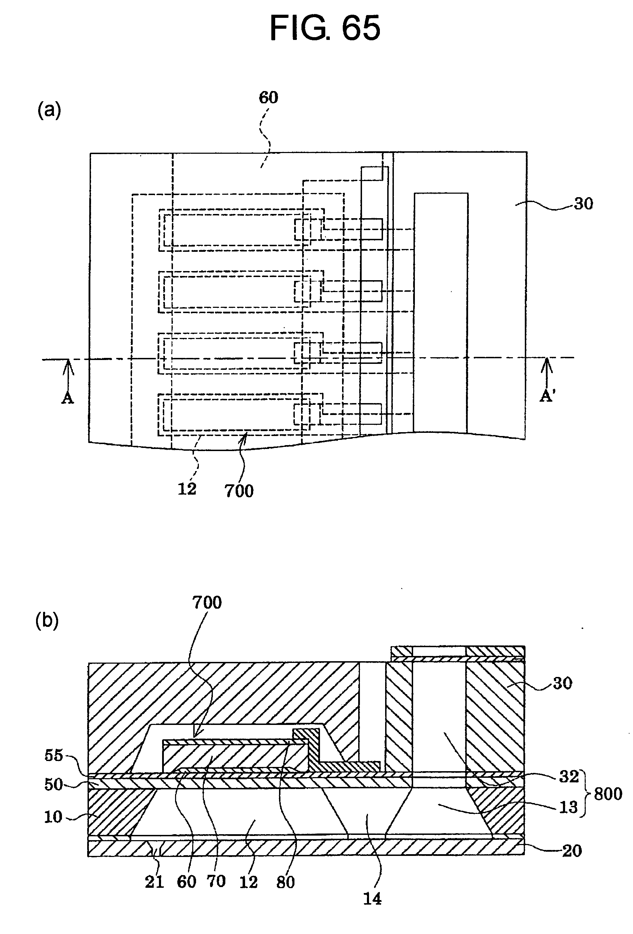

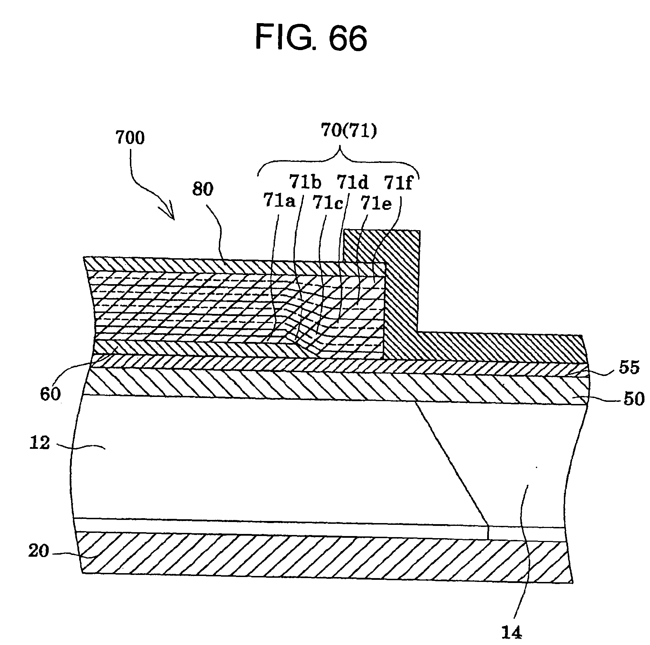

FIG. 64 is an exploded perspective view showing an ink-jet recording head in accordance with an embodiment of the present invention, and FIGS. 65 are a plan view and a cross-sectional view taken along a line A - A of FIG. 64, and FIG. 66 schematically shows a layered structure of a piezoelectric element 700. As shown in the figures, a passage-forming substrate 10 consists of a single crystal silicon substrate of a plane orientation (110) in the present embodiment, and on one surface thereof, an elastic film 50 having a thickness ranging from 1 to 2 µm is formed, which consists of silicon dioxide previously formed by thermal oxidation. In this passage-forming substrate 10, a plurality of pressure generating chambers 12 are arranged in its width direction. Moreover, adjacent to one respective end of the pressure generating chambers 12 in the longitudinal direction thereof, is formed a communicating portion 13, and the communicating portion 13 and each of the pressure generating chambers 12 communicate with each other through an ink supply passage 14 provided at each of the pressure generating chambers 12. It is noted that the communicating portion 13 communicates with a reservoir portion 32 provided in a sealing substrate 30 to be described later and constitutes a reservoir 800 that will be a common ink chamber to the respective pressure generating chambers 12. The ink supply passage 14 is formed with a width narrower than that of the pressure generating chamber 12, and maintains constant the passage resistance of ink flowing from the communicating portion 13 into the pressure generating chambers 12.

On the opening surface side of the passage-forming substrate 10, a nozzle plate 20 having nozzle orifices 21 drilled therein is fixedly adhered via an adhesive or a thermowelding film, each nozzle orifice 21 communicating with a respective pressure generating chamber 12 at a spot opposite to the ink supply passage 14.

The elastic film 50 described above having a thickness of, for example, about 1.0 µm, is provided on the passage-forming substrate 10 on the opposite side of the open surface thereof, and a dielectric film 55 having a thickness of, for example, about 0.4 µm, is provided on the elastic film 50. Further, on the dielectric film 55 is provided a lower electrode film 60 having a thickness of, for example, about 0.2 µm, a piezoelectric layer 70 having a thickness of, for example, about 1.0 µm, and an upper electrode film 80 having a thickness of, for example, about 0.05 µm, which are laminated by a process to be described below, thereby constituting the piezoelectric element 700. It is noted that the term piezoelectric element 700 refers to a portion including the lower electrode film 60, the piezoelectric layer 70 and the upper electrode film 80. In general, one of the electrodes of the piezoelectric element 300 is used as a common electrode, and the other electrode and the piezoelectric layer 70 are patterned for each pressure generating chamber 12. It is noted here that the portion which is constituted by the piezoelectric layer 70 and one of the patterned electrodes and causes piezoelectric strain by applications of voltages to the electrodes is called a piezoelectric active portion. In the present embodiment, the lower electrode film 60 is used as the common electrode of the piezoelectric element 700, and the upper electrode film 80 is used as discrete electrodes. However, their relation may be reversed without any trouble for the sake of convenience of wiring and a driving circuit. In any case, an piezoelectric active portion is formed for each pressure generating chamber. Furthermore, it is noted here that the piezoelectric element 700 and a vibration plate making a displacement owing to a drive of the piezoelectric element 700 is collectively referred to as a plurality of piezoelectric actuators. It is noted that the piezoelectric layer 70 is provided independently for each of the pressure generating chambers 12, and constitutes plural layers of ferroelectric films 71 (71 a - 71 f), as shown in FIG. 66.

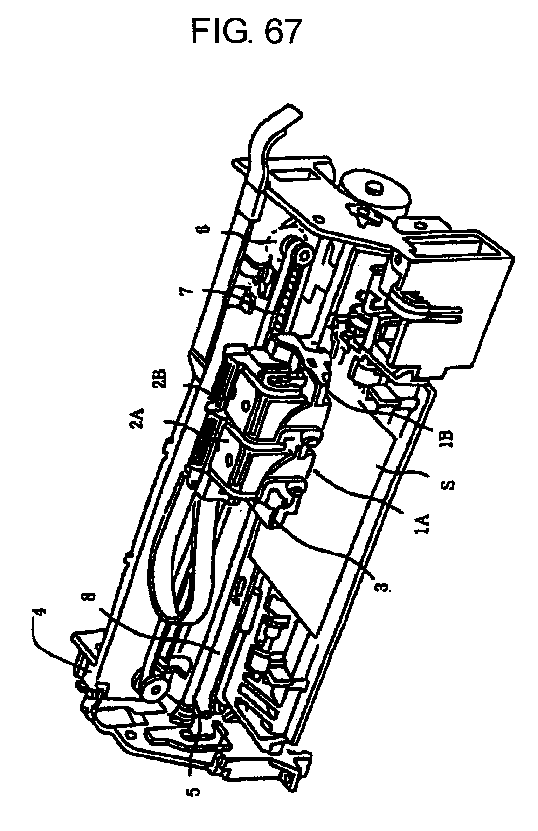

An ink-jet recording head constitutes a part of a recording head unit including an ink flow passage communicating with an ink cartridge and the like, and is mounted on an ink-jet recording apparatus. FIG. 67 is a schematic view showing one example of the ink-jet recording apparatus. As shown in FIG. 67, in recording head units 1A and 1B having the ink-jet recording heads, cartridges 2A and 2B constituting ink supplying means are detachably provided. A carriage 3 having these recording head units 1A and 1B mounted thereon is provided on a carriage shaft 5 attached to an apparatus body 4 so as to be freely movable in the shaft direction. These recording head units 1A and 1B, for example, are set to eject a black ink composition and a color ink composition, respectively. A driving force of a drive motor 6 is transmitted to the carriage 3 via a plurality of gears (not shown) and a timing belt 7, thereby moving the carriage 3 with the recording head units 1A and 1B mounted thereon along the carriage shaft 5. A platen 8 is provided on the apparatus body 4 along the carriage shaft 5, and a recording sheet S as a recording medium, such as, paper fed by a paper feed roller (not shown) or the like is conveyed onto the platen 8.

Although description has been made for the ink-jet recording head as one example as an ink jet head that ejects ink, the present invention concerns liquid jet heads that use piezoelectric elements and liquid jet apparatus in general. As liquid jet heads, for example, a recording head that is used for image recording apparatuses such as printers, a color material jet head that is used for manufacturing color filters for liquid crystal displays or the like, an electrode material jet head that is used for forming electrodes of organic EL displays, FEDs (face emission displays) and the like, a bio-organic material jet head that is used for manufacturing bio-chips, and the like can be enumerated.

The piezoelectric element in accordance with the present embodiment uses a PZTN film of the embodiment described above as its piezoelectric layer, and thus provides the following effects.
(1) Due to the fact that the covalent bond within the piezoelectric layer is improved, the piezoelectric constant can be improved.
(2) Due to the fact that PbO vacancies within the piezoelectric layer can be suppressed, generation of heterogenous phases at the interface between the piezoelectric layer and the electrode is suppressed, and an electric field can readily be applied, thereby improving the efficiency as a piezoelectric element.
(3) Due to the fact that the leakage current of the piezoelectric layer can be suppressed, the piezoelectric layer can be made thinner.
   The liquid jet head and the liquid jet apparatus in accordance with the present embodiment use the piezoelectric layer described above, and thus provides the following effects in particular.
(4) Due to the fact that fatigue deterioration of the piezoelectric layer can be alleviated, a change with the lapse of time in the amount of displacement of the piezoelectric layer can be suppressed, and therefore its reliability can be improved.

## Claims

1. A ferroelectric film comprised of a perovskite structure ferroelectric represented by ABO₃, **characterized by** including:
at least one type of Si²⁺, Ge²⁺ and Sn²⁺ as an A site compensating ion in an A site; and
Nb⁵⁺ as a B site compensating ion in a B site.

2. A ferroelectric film according to claim 1 wherein the ABO₃ includes oxygen ion vacancies, **characterized in that** the sum of a valence of the A site compensating ion and an excess valence in the entire B site caused by the B site compensating ion is equal to a shortage valence corresponding to the amount of the oxygen ion vacancies or smaller than the shortage valence.

3. A ferroelectric film according to claim 2, **characterized in that** the amount of the oxygen ion vacancies is 15 mol% or less with respect to a stoichiometric composition of the perovskite structure ferroelectric.

4. A ferroelectric film according to any one of claims 1 to 3, **characterized in that**
the amount of A site ions added is 16 mol% or less with respect to the stoichiometric composition of the perovskite structure ferroelectric, and
the amount of B site ions added is 30 mol% or less with respect to the stoichiometric composition of the perovskite structure ferroelectric.

5. A ferroelectric film according to any one of claims 1 to 4, **characterized in that** the perovskite structure ferroelectric is a PZT-based ferroelectric that includes Pb²⁺ as an A site ion, and Zr⁴⁺ and Ti⁴⁺ as a B site ion.

6. A ferroelectric film according to any one of claims 1 to 5, **characterized in that** the perovskite structure ferroelectric is composed of a (111) oriented tetragonal crystal structure.

7. A ferroelectric film according to any one of claims 1 to 5, **characterized in that** the perovskite structure ferroelectric is composed of a (001) oriented rhombohedral crystal structure.

8. A ferroelectric memory **characterized by** including the ferroelectric film recited in any one of claims 1 to 7.

9. A piezoelectric element **characterized by** including the ferroelectric film recited in any one of claims 1 to 7.
